(19) Europäisches Patentamt
European Patent Office
Office européen des brevets

(11) EP 2 058 834 B1

(12) EUROPEAN PATENT SPECIFICATION

(45) Date of publication and mention
of the grant of the patent:
09.12.2015 Bulletin 2015/50

(51) Int Cl.:
H01J 37/153 (2006.01)          H01J 37/12 (2006.01)
H01J 37/285 (2006.01)

(21) Application number: 07791379.6

(22) Date of filing: 26.07.2007

(86) International application number:
PCT/JP2007/064679

(87) International publication number:
WO 2008/013232 (31.01.2008 Gazette 2008/05)

(54) SPHERICAL ABERRATION CORRECTION DECELERATING LENS, SPHERICAL ABERRATION CORRECTION LENS SYSTEM, ELECTRON SPECTROSCOPY DEVICE, AND PHOTOELECTRON MICROSCOPE

VERZÖGERUNGSLINSE ZUR DER KORREKTUR DER SPHÄRISCHEN ABERRATION, LINSENSYSTEM MIT KORREKTUR DER SPHÄRISCHEN ABBERATION, ELEKTRONENSPEKTROSKOPIEEINRICHTUNG UND PHOTOELEKTRONEN-MIKROSKOP

LENTILLE À DÉCÉLÉRATION À CORRECTION D'ABERRATION SPHÉRIQUE, SYSTÈME DE LENTILLES À CORRECTION D'ABERRATION SPHÉRIQUE, DISPOSITIF DE SPECTROSCOPIE ÉLECTRONIQUE, ET MICROSCOPE À PHOTOÉLECTRONS

(84) Designated Contracting States:
DE GB SE

(30) Priority: 26.07.2006 JP 2006203318

(43) Date of publication of application:
13.05.2009 Bulletin 2009/20

(73) Proprietor: National University Corporation Nara Institute of
Science and Technology
Ikoma-shi, Nara 630-0192 (JP)

(72) Inventors:
• MATSUDA, Hiroyuki
Hyogo 678-0012 (JP)
• DAIMON, Hiroshi
Nara 630-0192 (JP)

(74) Representative: Treeby, Philip David William et al
RGC Jenkins & Co.
26 Caxton Street
London SW1H 0RJ (GB)

(56) References cited:
EP-A2- 1 170 778      WO-A1-2006/008840

JP-A- 08 111 199      JP-A- 2001 035 434
US-A- 4 358 680      US-B1- 6 492 644

• VAN NOORT H M ET AL: "Design of a new retarding-field electron spectrometer for depth-selective conversion electron Mossbauer spectroscopy", JOURNAL OF PHYSICS E. SCIENTIFIC INSTRUMENTS, IOP PUBLISHING, BRISTOL, GB, vol. 21, no. 6, 1 June 1988 (1988-06-01), pages 587-591, XP020018800, ISSN: 0022-3735, DOI: DOI:10.1088/0022-3735/21/6/014
• MATSUDA H ET AL: "APPROACH FOR SIMULTANEOUS MEASUREMENT OF TWO-DIMENSIONAL ANGULAR DISTRIBUTION OF CHARGED PARTICLES:SPHERICAL ABERRATION CORRECTION USING AN ALLIPSOIDAL MESH", PHYSICAL REVIEW E (STATISTICAL, NONLINEAR, AND SOFT MATTER PHYSICS), AMERICAN PHYSICAL SOCIETY, COLLEGE PARK, MD, US, vol. E71, 21 June 2005 (2005-06-21), pages 66503-1/8, XP003020696, ISSN: 1539-3755, DOI: DOI: 10.1103/PHYSREVE.71.066503
• MATSUDA H. ET AL.: 'Approach for simultaneous measurement of two-dimensional angular distribution of charged particles; Spherical aberration correction using an ellipsoidal mesh' PHYSICAL REVIEW E vol. 71, 2005, pages 066503.1 - 066503-8, XP003020696

**Description**

TECHNICAL FIELD

The present invention relates to an input lens of (i) an electron spectrometer such as XPS (photoelectron spectrometer) and AES (Auger electron spectrometer) and (ii) PEEM (photoelectron microscope).

BACKGROUND ART

In a conventional photoelectron spectrometer, it is often that an electrostatic lens referred to as "input lens" is used for an input portion of an energy analyzer (represented by an electrostatic hemispherical analyzer). The input lens, first, accepts electrons emitted from a sample as much as possible and decelerates the electrons so that the decelerated electrons are incident on an analyzer, thereby enhancing an energy resolution ability.

Further, there is a case where a function for limiting an electron acceptance angle in a sample surface is rendered to the electron spectrometer. In the electron spectrometer configured in this manner, its sensitivity is determined depending on a divergence angle (a solid angle) of electrons that the input lens accepts from the sample. Further, an energy analyzer having an imaging function images acceptance angular distribution so as to simultaneously measure angular dependencies of photoelectron energy peaks. In this case, it is possible to perform simultaneous measurement of acceptance angular dependencies of electrons from substantially parallel to perpendicular to a sample surface as long as the acceptance angle is over 90° (±45°), so that it is possible to efficiently measure depth dependencies of elements.

However, due to a spherical aberration, an ordinary electrostatic lens cannot converge a beam whose divergence angle is large into a single point. Specifically, a limit of its acceptance angle is around 30° (±15°).

Further, in a conventional photoelectron microscope, photoelectrons and secondary electrons emitted from a sample are accelerated so as to be incident on an objective lens, thereby realizing a large acceptance angle. However, if energy of electrons emitted from the sample becomes greater, the electrons are less likely to be bent. This may result in a smaller acceptance angle. Specifically, in case where the energy is over several hundreds eV, the acceptance angle is below 30° (±15°). If a large solid angle can be measured with the energy being set over several hundreds eV, atomic arrangement analysis such as photoelectronic diffraction and photoelectronic holography is possible. However, if the acceptance angle is below 30°, this is insufficient for the atomic arrangement analysis.

Further, in electron lenses, spherical aberration inevitably occurs, and it has been proved that in such an ordinary lens configuration that there is no space charge in an axially symmetrical manner, it is impossible to eliminate the spherical aberration. Thus, there has been carried out such trial that the same effect as that of introduction of space charge is brought about by placing a mesh electrode or a foil electrode in a certain point of the electron lens thereby correcting the spherical aberration.

In case of using the foil electrode, it is necessary to set electron energy high to some extent so that an electron beam passes through the foil electrode. The electron energy can be set high in a transmission electron microscope or the like, but such setting is hard to realize in an electron spectrometer which measures electrons having at most several keV energy. Further, it is necessary to make the foil electrode sufficiently thin so as to prevent scattering and absorption of electrons, which results in a problem that it is difficult to form the foil electrode into a curved shape.

Note that, a flat foil electrode is capable of eliminating third-order (lowest-order) spherical aberration, but it is difficult for the flat foil electrode to eliminate higher-order spherical aberration. In the electron microscope, essentially, the angle of acceptance of an electron beam is narrowed to an order of milliradian to obtain a high resolution ability, so that correction of the third-order spherical aberration is enough. However, with respect to a beam whose divergence angle is several dozen degree required in electron spectroscopy, the foil electrode fails to effectively correct its spherical aberration.

The aforementioned problem of the correction in the foil electrode can be solved by using a mesh electrode instead of the foil electrode. The use of the mesh electrode overcomes the problem of transmission and makes it easier to form the electrode into a curved shape than the foil electrode. Patent Document 1 and Non-Patent Document 1 describe an electron lens including a conventional mesh electrode.

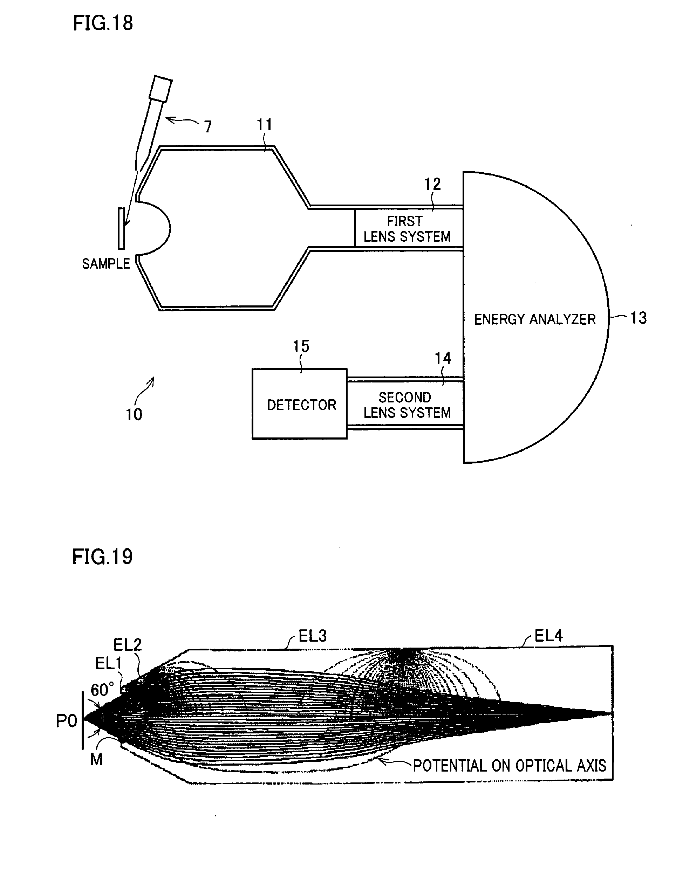

As illustrated in Fig. 19, Patent Document 1 describes a spherical aberration correction electrostatic lens including a spherical mesh. The spherical aberration correction electrostatic lens includes: a spherical mesh; and coaxial multistage-type (four or more staged) electrodes EL1 to ELn, wherein a decelerating field is formed in the mesh and an electrode provided in a periphery of the mesh, and an accelerating convergence field is formed in electrodes on the side of an image surface (including the n-th electrode ELn). The spherical aberration electrostatic lens of Fig. 19 is an einzel-type mesh lens including a mesh electrode and a plurality of electrodes. The einzel-type mesh lens is such that a combination of a decelerating field in the periphery of the mesh electrode and a subsequent accelerating convergence field converges a beam whose divergence angle is large. Electrons entering the lens are decelerated but are soon accelerated, so that the electrons have at the exit the same energy as that at the entrance. In the spherical aberration electrostatic lens arranged in this manner, a beam acceptance angle is increased to around ±30°.

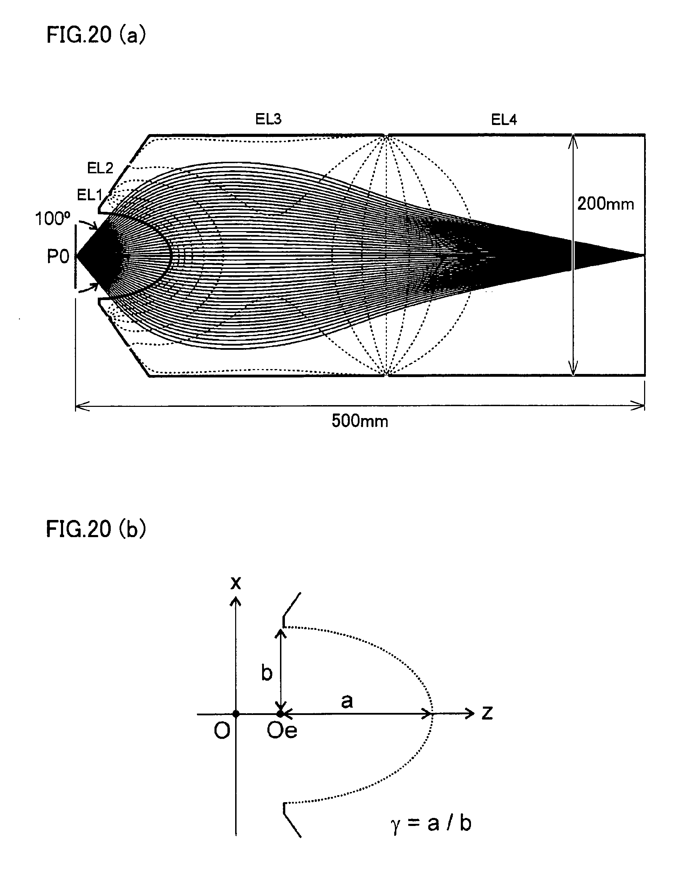

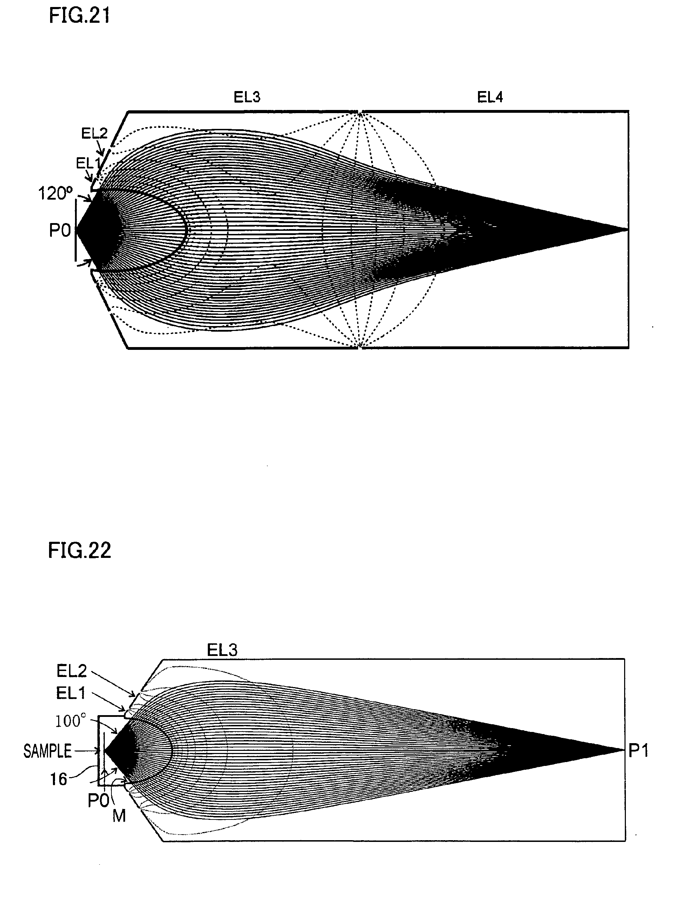

Further, Non-Patent Document 1 describes, as illustrated in Fig. 20(a), an einzel-type mesh lens including a spheroidal mesh, whose central axis coincides with an optical axis, instead of the spherical mesh used in the spherical aberration correction electrostatic lens of Patent Document 1. The einzel-type mesh lens described in Non-Patent Document 1 is configured as follows. As illustrated in Fig. 20(b), there is adjusted "γ=a/b" indicative of a ratio of a major axis to a minor axis where "a" represents a major axis radius of the spheroidal surface and "b" represents a minor radius of the spheroidal surface with an origin Oe of the spheroidal surface regarded as its center, thereby increasing the beam acceptance angle to around ±60° as illustrated in Fig. 21.

US4358680 relates to an electron spectrometer including a hemispherical analyzer and a multi-element optical lens system. The lens system has, at its entrance, two spaced apart mesh elements which are concave toward the sample, for reducing the lens aberrations, and switching means operable to change the potentials on the lens elements.

EP1170778 relates to an instrument for analysis of a specimen surface comprising an electron gun for producing a focused electron beam, an anode with an anode surface disposed to receive the focused electron beam so as to generate x-rays from an anode spot on the anode surface, rastering means for rastering the focused electron beam over the anode surface, thereby scanning the anode spot over the anode surface, focusing means receptive of at least a portion of the x-rays from the scanning anode spot for focusing an energy band of x-rays of predetermined energy as an x-ray spot on a pixel area scanning correspondingly over the specimen surface, such that photoelectrons are emitted from the scanning pixel area with electron energies characteristic of chemical species at the pixel area.

Matsuda H et Al, in "Approach for Simultaneous Measurement of Two-Dimensional Angular Distribution of Charged Particles: Spherical Aberration Correction Using an Allipsoidal Mesh" [Non-Patent Document 1: Physical Review E (Statistical, Nonlinear, and Soft Matter Physics), American Physical Society, College Park, MD, US], discuss an approach for simultaneous measurement of two-dimensional angular distribution of charged particles concerning spherical aberration correction in electrostatic lenses with the potential use of a mesh.

[Patent Document 1] Japanese Unexamined Patent Publication No. 111199/1996 (Tokukaihei 08-111199) (Publication date: April 30, 1996)

[Non-Patent Document 1] PHYSICAL REVIEW E71, 066503 (2005) (Publication date: June 28, 2005)

DISCLOSURE OF INVENTION

As described in Patent Document 1 and Non-Patent Document 1, a spherical or spheroidal mesh is used to constitute an electron lens, so that the electron lens realizes a large acceptance angle such as around ±60°. The electron lens is expected not only to realize a large acceptance angle but also to be capable of measuring a beam having high energy over several hundreds eV and having a large divergence angle. If the electron lens can measure a beam having high energy over several hundreds eV and having a large divergence angle, it is possible to perform the atomic arrangement analysis such as photoelectronic diffraction and photoelectronic holography.

However, according to the foregoing conventional configuration, even if the einzel-type mesh lens can converge the beam having high energy over several hundreds eV and having a large divergence angle, the divergence angle of the beam does not become sufficiently small. Thus, if a lens is provided on a subsequent stage and entry of the beam is continued under this condition, blur occurs on an image plane. As a result, it is necessary to apply a high voltage to an electrode of the subsequent stage lens. For example, in case where a beam whose energy is around 10 keV is emitted from a sample, a voltage which is 100 times as high as a voltage required in converging a beam having low energy such as around 100 eV has to be used to converge the foregoing beam at an image plane of the subsequent stage lens. This raises a withstand-voltage problem in the electron lens, so that it is difficult to converge the beam.

As described above, according to the foregoing conventional configuration, in case where a beam having high energy over several hundreds eV is incident on the electron lens, an acceptance angle of the electron lens is below around ±30°. This is insufficient for the atomic arrangement analysis.

The present invention was made in view of the foregoing problems, and an object of the present invention is to provide a spherical aberration correction decelerating lens, a spherical aberration correction lens system, an electron spectrometer, and a photoelectron microscope, each of which converges, at an image plane, a beam emitted from a sample and having high energy and a large divergence angle.

In order to solve the foregoing problems, a spherical aberration correction decelerating lens of the present invention is as set out in claim 1. Further aspects of the spherical aberration correction decelerating lens are set out in claims 2- 8.

According to this configuration, an intentionally set voltage is applied from the external power supply to at least three electrodes each of which is constituted of a surface of a solid of revolution whose central axis coincides with an optical axis, so that each electrode can decelerate a beam emitted from a predetermined object plane position and can form a decelerating convergent field for correcting a spherical aberration occurring in the beam. Thus, even in case where a high energy beam is emitted from the object plane, the decelerating convergent field formed by each electrode can decelerate the beam.

Further, the mesh in the spherical aberration correction decelerating lens as set out in claim 1 has a concaved shape opposite to an object plane and which is constituted of a surface of a solid of revolution so that a central axis of the concaved shape coincides with the optical axis. This makes it possible to realize a large acceptance angle. Hence, in case where a beam having high energy and a large divergence angle is made to be incident on the spherical aberration correction decelerating lens of the present invention and the beam converged at the image plane is kept incident on a lens provided at a subsequent stage, it is possible to converge the beam at an image plane of the subsequent stage lens without applying a high voltage to an electrode of the subsequent stage lens.

Thus, in case where the spherical aberration correction decelerating lens of the present invention is applied to an electron spectrometer or a photoelectron microscope, it is possible to allow a beam having high energy and a large divergence angle to be incident thereon, so that it is possible to greatly enhance sensitivities and functions of the electron spectrometer and the photoelectron microscope.

A spherical aberration correction lens system of the present invention is as set out in claim 9.

Generally, an electron lens is accompanied by a positive spherical aberration regardless of whether the electron lens is an electrostatic type or a magnetic field type. Thus, as a beam emitted from a certain point of an object plane has a larger aperture angle with respect to the electron lens, a resultant image is formed at a position closer to the object plane. Hence, as the electron lens has a larger acceptance angle, the resultant image is more blurred.

Therefore, in case where a general electron lens, i.e., an electron lens accompanied by a positive spherical aberration is used as the first lens or the second lens of the spherical aberration correction lens system of the present invention, a lens bringing about a negative spherical aberration is used as the other lens to appropriately give the negative spherical aberration so that the lens cancels the positive spherical aberration of the electron lens. Thus, as to the beam emitted from the object plane, the spherical aberration is cancelled at the image plane of the second lens. Specifically, as to a real image formed in the first lens and having a positive or negative spherical aberration, its positive or negative spherical aberration is cancelled by the second lens disposed at the subsequent stage of the first lens whose axis coincides with the optical axis of the first lens.

Thus, for example, by using a lens having a mesh and bringing about a negative spherical aberration as the first lens and by using a lens bringing about a positive spherical aberration as the second lens, the first lens can accept the beam from the object plane so that an acceptance angle of the beam is within the range of $\pm 50°$ to $\pm 60°$. Further, by giving an appropriate negative spherical aberration in the second lens so as to correct a positive spherical aberration occurring in the first lens, it is possible to cancel, on the image plane of the second lens, the large positive spherical aberration occurring in the first lens.

Also, for example, in case of using as the first lens a lens having a mesh and bringing about a positive spherical aberration and using as the second lens a lens accompanied by a negative spherical aberration (e.g., a multipolar lens), the first lens can accept the beam from the object plane so that an acceptance angle of the beam is within a range from $\pm 50°$ to $\pm 60°$. Further, by giving an appropriate positive spherical aberration in the first lens so as to correct a negative spherical aberration occurring in the second lens, it is possible to cancel, on the image plane of the second lens, the negative spherical aberration occurring in the first lens.

Hence, the spherical aberration correction lens system of the present invention can cancel, on the image plane of the subsequent stage lens, the spherical aberration of the beam emitted from the object plane.

Therefore, in case where the spherical aberration correction lens system is applied to an electron spectrometer or a photoelectron microscope, spatial resolution can be improved compared with the case where the spherical aberration is corrected by using only the previous stage lens.

An electron spectrometer of the present invention is as described in claim 10.

According to this arrangement, by using the spherical aberration correction decelerating lens or the spherical aberration correction lens system which can accept a high energy beam with a large acceptance angle, it is possible to greatly enhance sensitivity and function of the electron spectrometer.

A photoelectron microscope of the present invention is as described in claim 11.

According to this arrangement, by using the spherical aberration correction decelerating lens or the spherical aberration correction lens system which can accept a high energy beam with a large acceptance angle, it is possible to greatly enhance sensitivity and function of the photoelectron microscope.

BRIEF DESCRIPTION OF DRAWINGS

Fig. 1 is a cross sectional view schematically illustrating a configuration of an example of a spherical aberration correction decelerating lens according to the present invention.

Fig. 2(a) is a cross sectional view illustrating a configuration of a spherical aberration correction decelerating lens whose acceptance angle is ±50°.

Fig. 2(b) is a cross sectional view illustrating a configuration of a spherical aberration correction decelerating lens whose acceptance angle is ±60°.

Fig. 3 is a diagram illustrating essential portions of the spherical aberration correction decelerating lens of Fig. 2(a).

Fig. 4 is a diagram illustrating essential portions of the spherical aberration correction decelerating lens of Fig. 2(b).

Fig. 5 is a graph illustrating a relationship between a ratio of a major axis to a minor axis in a mesh M and a spherical aberration.

Fig. 6 is a cross sectional view illustrating a spherical aberration correction decelerating lens including a spherical mesh whose central axis coincides with an optical axis.

Fig. 7 is a diagram illustrating essential portions of a spherical mesh whose central axis coincides with an optical axis of the spherical aberration correction decelerating lens of Fig. 6.

Fig. 8 is a cross sectional view illustrating a spherical aberration correction decelerating lens provided with two spherical meshes, i.e., an internal spherical mesh and an external spherical mesh.

Fig. 9 is a diagram illustrating essential portions of the two spherical meshes, i.e., the internal spherical mesh and the external spherical mesh of Fig. 8.

Fig. 10(a) is a cross sectional view illustrating electron trajectories in case where a beam whose divergence angle is ± 12° is incident on a subsequent stage lens in a lens system including two lenses, i.e., a previous stage lens and the subsequent stage lens.

Fig. 10(b) is a cross sectional view illustrating electron trajectories calculated so that the beam is converged at a single point on an image plane P2 of the subsequent stage lens in the lens system of Fig. 10(a).

Fig. 11 is a cross sectional view schematically illustrating a configuration of a spherical aberration correction lens system of Example 1.

Fig. 12 is a graph illustrating a relationship between an incident angle of a beam and a spherical aberration in case where a ratio $\gamma$ of a major axis to a minor axis of the mesh M is 1.44, in case of 1.47, in case of 1.50, in case of 1.53, and in case of 1.56.

Fig. 13 is a graph illustrating a relationship between an incident angle of a beam and a spherical aberration in case where a voltage $V_2$ applied to a second electrode EL2 is -490V, in case of -460V, in case of -443V, in case of -430V, and in case of -400V.

Fig. 14(a) is a cross sectional view illustrating a configuration of the spherical aberration correction decelerating lens of Example 1.

Fig. 14(b) is a graph illustrating a relationship between an incident angle of a beam and a spherical aberration on an image plane P1 of the first lens E1 and a relationship between the incident angle of the beam and a spherical aberration on an image plane P2 of the second lens E2 in the spherical aberration correction lens system of Fig. 14(a).

Fig. 15(a) is a cross sectional view illustrating a configuration of a spherical aberration correction lens system of Example 2.

Fig. 15(b) is a graph illustrating a relationship between an incident angle of a beam and a spherical aberration on an image plane P1 of the first lens E1 and a relationship between the incident angle of the beam and a spherical aberration on an image plane P2 of the second lens E2 in the spherical aberration correction lens system of Fig. 15(a).

Fig. 16 is a cross sectional view schematically illustrating a configuration of a spherical aberration correction lens system of Example 3.

Fig. 17 is a block diagram illustrating an example of an electron spectrometer of the present invention.

Fig. 18 is a block diagram illustrating an example of a photoelectron microscope according to the present invention.

Fig. 19 is a cross sectional view illustrating a spherical aberration correction electrostatic lens including a conventional spherical mesh.

Fig. 20(a) is a cross sectional view illustrating an einzel-type mesh lens, including a conventional spheroidal mesh, whose acceptance angle is ±50°.

Fig. 20(b) is a design drawing of a mesh of the einzel-type mesh lens of Fig. 20(a).

Fig. 21 is a cross sectional view illustrating an einzel-type mesh lens, including a conventional spheroidal mesh, whose acceptance angle is ±60°.

Fig. 22 is a diagram illustrating a configuration in which a shield for keeping a potential of a periphery of a sample constant in a spherical aberration correction decelerating lens of Fig. 2(a).

[Reference Numerals and Signs]

1              Electron spectrometer

| | |
|---|---|
| 2 | Input lens |
| 3 | Spherical mirror analyzer |
| 4 | Aperture |
| 5 | Micro channel plate (MCP) |
| 6 | Screen |
| 7 | Emission member |
| 10 | Photoelectron microscope |
| 11 | Objective lens |
| 12 | First lens system |
| 13 | Energy analyzer |
| 14 | Second lens system |
| 15 | Detector |
| 16 | Shield |
| EL1 to ELn | First electrode to n-th electrode |
| E1 | First lens |
| E2 | Second lens |
| P0 | Object plane |
| P1 | Image plane |
| P2 | Image plane |
| Oe | Origin of spheroidal surface of mesh M |
| a | Major axis of spheroidal surface |
| b | Minor axis of spheroidal surface |
| $\gamma$ | Ratio of major axis to minor axis in spheroidal surface of mesh M |
| d1 | Distance between object plane and mesh M |
| L1 | Length of first electrode EL1 |
| L2 | Length of second electrode EL2 |
| S1 | Internal spherical mesh |
| S2 | External spherical mesh |
| r1 | Radius of internal spherical mesh |
| r2 | Radius of external spherical mesh |

BEST MODE FOR CARRYING OUT THE INVENTION

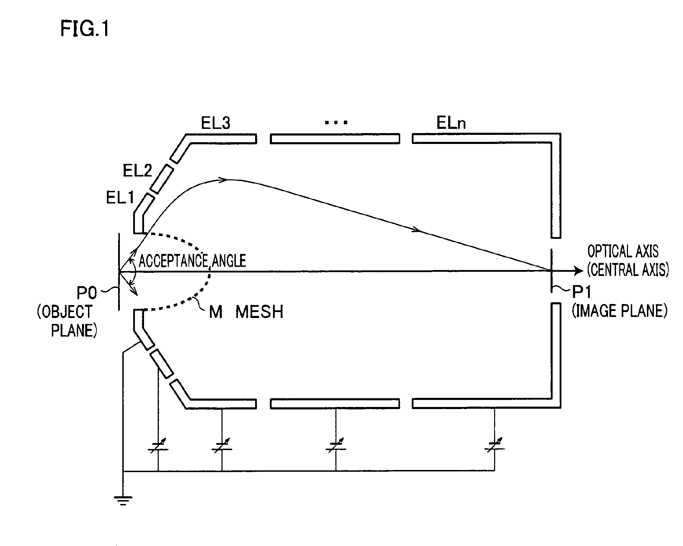

One embodiment of the present invention as well as examples useful for understanding the present invention are described below with reference to Fig. 1 to Fig. 17.

A spherical aberration correction decelerating lens of the present invention corrects a spherical aberration occurring in an electron beam or an ion beam (hereinafter, referred to as "beam").

[Spherical aberration correction decelerating lens]

Principles of the spherical aberration correction decelerating lens are described as follows with reference to Fig. 1 to Fig. 9. Fig. 1 is a cross sectional view schematically illustrating a configuration of an example of the spherical aberration correction decelerating lens according to the present invention. Note that, a curve indicated by an arrow of Fig. 1 shows a trajectory of a beam emitted from a sample.

As illustrated in Fig. 1, the spherical aberration correction decelerating lens of the present embodiment includes a mesh M and a first electrode EL1 to an n-th electrode ELn. In a conventional einzel-type mesh lens, the first electrode EL1 to the n-th electrode ELn decelerate and then accelerate the beam emitted from the object plane P0, thereby forming an accelerating convergence field for performing convergence at the image plane P1. However, the spherical aberration correction decelerating lens of the present embodiment does not form the accelerating convergence field but forms a decelerating convergence field for converging the beam, emitted from the object plane P0, onto the image plane P1 while decelerating the beam.

The spherical aberration correction decelerating lens can be favorably used as an input lens of an electron spectrometer and an objective lens of a photoelectron microscope.

The mesh M has a concaved shape opposite to the object plane P0 on which a sample is placed and is constituted of a spheroidal surface whose central axis coincides with an optical axis of the spherical aberration correction decelerating lens. Further, the mesh M is integrally provided on the first electrode EL1. Note that, in the present embodiment, the mesh M is constituted of the spheroidal surface whose central axis coincides with the optical axis. In an example merely for understanding the invention, the mesh M may be constituted of a spherical surface whose central axis coincides with the optical axis. As described below, the configuration in which the mesh M is constituted of the spheroidal surface whose central axis coincides with the optical axis more surely increases an acceptance angle of the beam from the object plane, that is, the beam emitted from the sample, to around ±60°, than the configuration in which the mesh M is constituted of the spherical surface whose central axis coincides with the optical axis. Hence, in the present invention, the mesh M is constituted of the spheroidal surface whose central axis coincides with the optical axis. Further, in the present embodiment, the mesh M is integrally provided on the first electrode EL1, but the present invention is not limited to this configuration and the mesh M may be provided separately from the first electrode EL1.

Each of the first electrode EL1 to n-th electrode ELn is constituted of a surface of a solid of revolution whose central axis coincides with the optical axis of the spherical aberration correction decelerating lens of the present embodiment and has a concentric surface forming a decelerating convergence field. The first electrode EL1 to n-th electrode ELn are disposed in an order starting from the mesh M along the optical axis. An intentionally set voltage is applied from an external power supply to each electrode. Note that, since the mesh M is integrally provided on the first electrode EL1, the same voltage is applied to the mesh M as a voltage applied to the first electrode EL1. Further, in case where the mesh M is provided separately from the first electrode EL1, an intentionally set voltage is applied to the mesh M and another intentionally set voltage is applied to the first electrode EL1.

In the spherical aberration correction decelerating lens, as a larger number of electrodes are provided, a convergence ability of the lens is more enhanced and a permissible error in the production steps of the lens further increases. However, the larger number of electrodes results in troublesome production steps of the spherical aberration correction decelerating lens. Hence, it is preferable that the number of electrodes is within a range from 3 to 10.

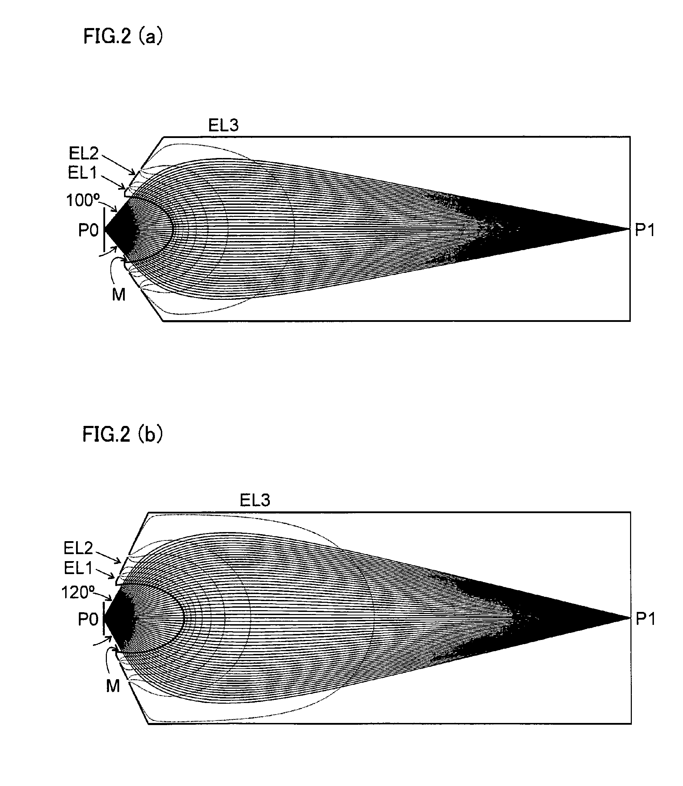

Here, with reference to Fig. 2 to Fig. 4, the following describes a configuration for causing the spherical aberration correction decelerating lens of the present embodiment to converge the beam emitted from the sample onto the image plane P1. Fig. 2(a) is a cross sectional view (an acceptance angle is illustrated as "50°×2, 100°" in this figure) illustrating a configuration of a spherical aberration correction decelerating lens whose acceptance angle is ±50°. Fig. 2(b) is a cross sectional view (an acceptance angle is illustrated as "60°×2, 120°" in this figure) illustrating a configuration of a spherical aberration correction decelerating lens whose acceptance angle is ±60°. Note that, in these figures, each dotted line indicates potential distribution and each continuous line indicates an electron trajectory.

Compared with the acceleration lens or the einzel-type lens, a conventional decelerating lens brings about more significant problem in spherical aberration. Unless the beam acceptance angle is increased, it is impossible to converge the beam. Thus, the conventional decelerating lens cannot be favorably used as an input lens of an electron spectrometer or an objective lens of a photoelectron microscope. However, as described above, the spherical aberration correction decelerating lens of the present embodiment is configured so that only a decelerating convergence field is formed by each electrode but the spherical aberration correction decelerating lens can converge a beam having a large divergence angle.

As illustrated in Fig. 2(a) and Fig. 2(b), the spherical aberration correction decelerating lens of the present embodiment includes three electrodes, i.e., the first electrode EL1, the second electrode EL2, and a third electrode EL3. Only the decelerating convergence field is formed by each electrode, but a beam which is incident thereon with a divergence angle of ±50° or ±60° can be converged onto the image plane P1.

In order to realize such a lens, the arrangement of the three electrodes, i.e., the first electrode EL1, the second electrode EL2, and the third electrode EL3, is important. The arrangement of the electrodes may be altered variously, but it is preferable that the electrodes are arranged with suitable distances from an outermost trajectory of the beam so as not to prevent the beam trajectory and so as to effectively give a spherical aberration correction effect to the beam.

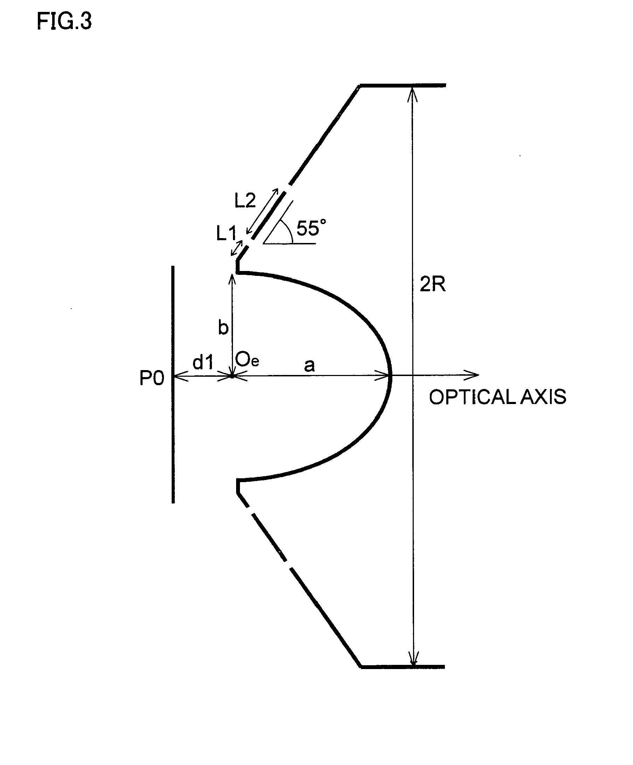

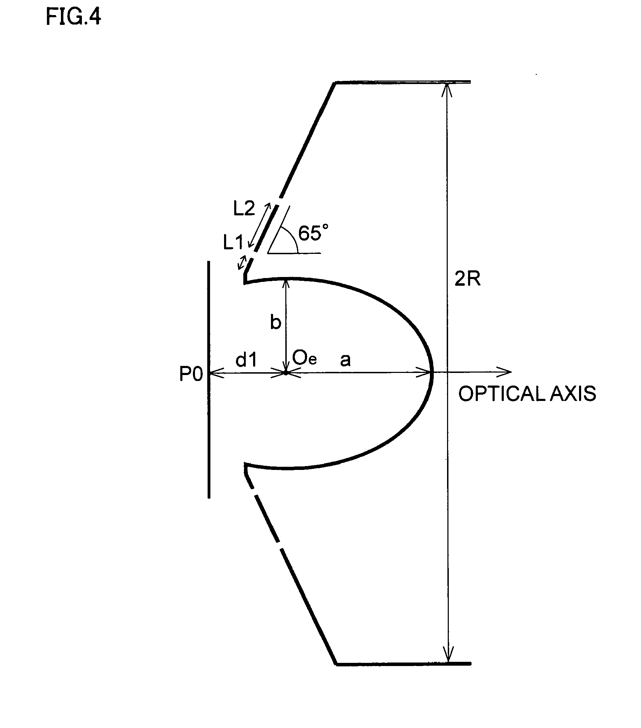

Fig. 3 illustrates essential portions of the spherical aberration correction decelerating lens of Fig. 2(a), and Fig. 4 illustrates essential portions of the spherical aberration correction decelerating lens of Fig. 2(b). In order to arrange the electrodes with suitable distances from the outermost trajectory of the beam, as illustrated in Fig. 3 and Fig. 4, each electrode is inclined with respect to an axis parallel to the optical axis by 55° in Fig. 2(a) and each electrode is inclined with respect to the axis parallel to the optical axis by 65° in Fig. 2(b). With such an arrangement of the electrodes, the following four values are important in configuring the spherical aberration correction decelerating lens of the present embodiment in which only the decelerating convergence field is formed and a beam which is incident thereon with a large divergence angle is converged onto the image plane P1.

(1) A ratio of a major axis to a minor axis in the concaved shape of the mesh M
(2) A length of each of the first electrode EL1 to the n-th electrode ELn
(3) A distance d1 from the object plane P0 to the origin Oe of the spheroidal surface of the mesh M
(4) A voltage applied to each of the first electrode EL1 to the n-th electrode ELn

The following describes the four values in the spherical aberration correction decelerating lens of Fig. 2(a) and the spherical aberration correction decelerating lens of Fig. 2(b).

First, with reference to Fig. 3, the design of the spherical aberration correction decelerating lens of Fig. 2(a) is specifically described. Fig. 3 illustrates essential portions of the spherical aberration correction decelerating lens of Fig. 2(a). Note that, this shows a case where a distance from the object plane P0 to the image plane P1 is 500 mm.

(1) $\gamma$ = a/b indicative of the ratio of a major axis to a minor axis in the concaved shape of the mesh M is 1.50 where "a" represents a major axis radius of the spheroidal surface and "b" represents a minor axis radius of the spheroidal surface with the origin Oe of the spheroidal surface of the mesh M being regarded as a center.
(2) A length L1 of the first electrode EL1 is 5.25 mm and a length L2 of the second electrode LE2 is 17.34 mm.
(3) The distance d1 from the object plane P0 to the origin Oe of the spheroidal surface of the mesh M is 18.83 mm.
(4) In case where energy of the beam emitted from the sample is 1 keV, the voltage applied to the first electrode EL1 is 0V, the voltage applied to the second electrode EL2 is -443.96V, the voltage applied to the third electrode EL3 is -819.82V.

In the spherical aberration correction decelerating lens configured in the foregoing manner, when a beam emitted from the sample and having energy of 1keV is incident thereon, the beam is decelerated down to around 180eV at an exit of the lens.
Next, with reference to Fig. 4, the design of the spherical aberration correction decelerating lens of Fig. 2(b) is specifically described. Note that, this shows a case where the distance from the object plane P0 to the image plane P1 is 500 mm.

(1) $\gamma$ = a/b indicative of the ratio of a major axis to a minor axis in the concaved shape of the mesh M is 1.51.
(2) The length L1 of the first electrode is 5.69 mm, the length L2 of the second electrode LE2 is 17.65 mm.
(3) The distance d1 from the object plane P0 to the origin Oe of the spheroidal surface of the mesh M is 26.90 mm.
(4) In case where energy of the beam emitted from the sample is 1 keV, the voltage applied to the first electrode EL1 is 0V, the voltage applied to the second electrode EL2 is -423.85V, the voltage applied to the third electrode EL3 is -806.04V.

In the spherical aberration correction decelerating lens configured in the foregoing manner, when a beam emitted from the sample and having energy of 1keV is incident thereon, the beam is decelerated down to around 194eV at an exit of the lens.
As described above, in case where the values of the four items (1) to (4) are set and the distance from the object plane P0 to the image plane P1 is 500 mm, the blur of the beam on the image plane P1 is below around 0.1 mm in any case.
The shape of the mesh M cannot completely eliminate the spherical aberration as long as the shape is exactly the spheroidal surface, which may result in occurrence of the blur on the image plane P1. Thus, in case where it is necessary to completely eliminate the spherical aberration, it is preferable that the spheroidal surface of the mesh M is further adjusted finely. The fine adjustment of the shape of the mesh M can be performed by defining a variation $\Delta R(\theta)$ from an ellipsoid of the shape of the mesh M having been finely adjusted on the basis of the following equation and optimizing parameters a0, a1 to an or parameters c1 to cn, p1 to pn, and q1 to qn so that the spherical aberration is minimized.

$$\Delta R(\theta) = a_0 + a_1\cos(\theta) + a_2\cos(2\theta) + a_3\cos(3\theta) + \cdots + a_n\cos(n\theta) \quad [\text{Equation 1}]$$

$$\Delta R(\theta) = c_1\sin^{p1}(\theta)\cos^{q1}(\theta) + c_2\sin^{p2}(\theta)\cos^{q2}(\theta) + \cdots + c_n\sin^{pn}(\theta)\cos^{qn}(\theta) \quad [\text{Equation 2}]$$

Note that, the variation $\Delta R(\theta)$ is an amount indicative of how the finely adjusted mesh shape varies with respect to a distance R from the origin O to the ellipsoid in case where a polar coordinate centering the origin O on the object plane is expressed as (R, $\theta$).
As described above, in case where the polar coordinate centering the origin O on the object plane is expressed as (R, $\theta$), the adjustment amount $\Delta R$ is expressed as a total of at least three functions with the "$\theta$" being a variable.
Note that, the values of the four items (1) to (4) are suitably adjusted with a change in the number of electrodes provided on the spherical aberration correction decelerating lens or with a change in the energy of the beam emitted from the sample. Further, all of the values of the four items (1) to (4) do not have to be adjusted, and it is possible to correct the spherical aberration by adjusting at least one of the values of the four items (1) to (4). However, it is preferable to simultaneously adjust a plurality of elements in realizing high convergence. Also in the spherical aberration correction decelerating lens illustrated in each of Fig. 2(a) and Fig. 2(b), the values of the items (1) to (4) are not limited to the aforementioned numerical values, and each of the values has a favorable range. Each value is adjusted within the favorable range, thereby converging the beam emitted from the object plane P0 onto the image plane P1.

The following describes the favorable range of each of the values of the four items which is applied in case where the distance from the object plane P0 to the image plane P1 is 500 mm and energy of the beam emitted from the sample is 1keV in the spherical aberration correction decelerating lens of the present embodiment which includes the first electrode EL1, the second electrode EL2, and the third electrode EL3, and whose acceptance angle is $\pm 50°$.

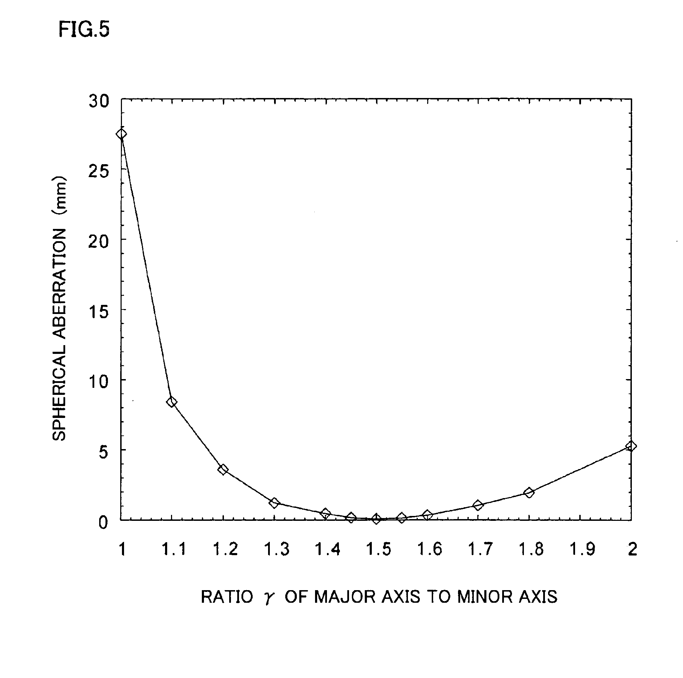

First, with reference to Fig. 5, the value in the item (1), i.e., the ratio of a major axis to a minor axis in the concaved shape of the mesh M is described. Fig. 5 is a graph illustrating a relationship between the ratio of a major axis to a minor axis in the mesh M and the spherical aberration. As illustrated in Fig. 5, the spherical aberration decreases down to a range from around 27.5 mm to around 0 mm in case where $\gamma = a/b$ indicative of the ratio of a major axis to a minor axis in the mesh M is in a range from 1 to 1.5, and the spherical aberration increases up to a range from around 0 mm to around 5 mm in case where $\gamma = a/b$ is in a range from 1.5 to 2. Thus, in case where $\gamma = a/b$ is in a range from around 1.4 to around 1.6, the spherical aberration is minimized. As a specific numerical value, the spherical aberration is around 0.4 mm or less. That is, under the foregoing condition, it is preferable that the value of the item (1), i.e., $\gamma = a/b$ indicative of the ratio of a major axis to a minor axis in the concaved shape of the mesh M is in a range from around 1.4 to around 1.6.

Next, the following describes the values of the item (2), i.e., the length L1 of the first electrode EL1 and the length L2 of the second electrode EL2. Under the foregoing condition, it is preferable that, in the values of the item (2), the length L1 of the first electrode EL1 is within a range from around 1 mm to around 10 mm and the length L2 of the second electrode EL2 is within a range from around 5 mm to around 25 mm.

Next, the following describes the value of the item (3), i.e., the distance d1 from the object plane P0 to the origin Oe of the spheroidal surface of the mesh M. Under the foregoing condition, it is preferable that the value of the item (3), i.e., the distance d1 from the object plane P0 to the origin Oe of the spheroidal surface of the mesh M is within a range from around 10 mm to around 25 mm.

Next, the following describes the values of the item (4), i.e., voltages applied to the first electrode EL1 to the n-th electrode ELn in (4). Under the foregoing condition, it is preferable that, in the item (4), a voltage applied to the first electrode EL1 is 0V, a voltage applied to the second electrode EL2 ranges from around -100V to around -550V, and a voltage applied to the third electrode EL3 ranges from around -550V to around -950V.

As described above, the foregoing values of the four items are adjusted in accordance with energy and an acceptance angle of the beam, thereby correcting the spherical aberration so that the acceptance angle is within $\pm 60°$. Note that, each of the foregoing values of the four items suitably varies in accordance with the number of electrodes provided on the spherical aberration correction decelerating lens and energy of the beam emitted from the sample. In case where the energy of the beam varies after the adjustment, the voltage applied to each electrode is varied relative to the energy of the beam.

Note that, the shape of the mesh M is constituted of the spheroidal surface whose central axis coincides with the optical axis in the present embodiment. As described above, in an example useful for understanding the invention, the shape of the mesh M may be constituted of a spherical surface whose central axis coincides with the optical axis (hereinafter, this is referred to as "spherical mesh").

In this case, the ratio of a major axis to a minor axis in the concaved shape of the mesh M, i.e., $\gamma = a/b$ in the item (1) is always 1, so that it is possible to converge the beam emitted from the object plane P0 onto the image plane P1 by adjusting three values other than the value of the item (1), i.e., the lengths of the first electrode EL1 to the n-th electrode ELn in the item (2), the distance from the object plane P0 to the mesh M in the item (3), and the voltages applied to the first electrode EL1 to the n-th electrode ELn in the item (4).

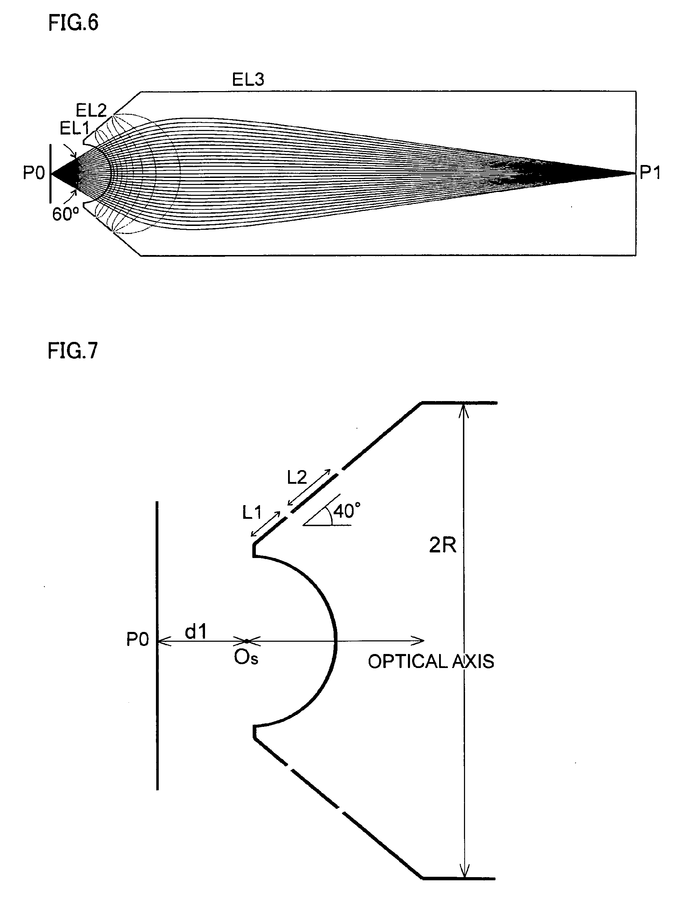

With reference to Fig. 6 and Fig. 7, the following describes the values of the three items (2) to (4) in case of using the spherical mesh as the mesh M. Fig. 6 is a cross sectional view illustrating a spherical aberration correction decelerating lens including a mesh constituted of a spherical surface whose central axis coincides with the optical axis. Fig. 7 illustrates essential portions of the mesh constituted of a spherical surface whose central axis coincides with the optical axis of the spherical aberration correction decelerating lens of Fig. 6.

As illustrated in Fig. 6, the spherical aberration correction decelerating lens including the spherical mesh is provided with three electrodes, i.e., the first electrode EL1, the second electrode EL2, and the third electrode EL3, and converges a beam which is incident thereon with a divergence angle of $\pm 30°$ onto the image plane P1. The following describes the values of the items (2) to (4) for converging the beam which is incident thereon with a divergence angle of $\pm 30°$ onto the image plane P1 in the spherical aberration correction decelerating lens configured in the foregoing manner.

(2) The length L1 of the first electrode EL1 is 12.40 mm, and the length L2 of the second electrode EL2 is 17.70 mm.
(3) The distance d1 from the object plane P0 to the mesh M is 27.50 mm.

(4) In case where energy of the beam emitted from the sample is 1keV, the voltage applied to the first electrode EL1 is 0V, the voltage applied to the second electrode EL2 is -380.25V, and the voltage applied to the third electrode EL3 is -888.29V.

However, the values of the items (2) and (3) are obtained in case where the distance from the object plane P0 to the image plane P1 is 500 mm.

In the spherical aberration correction decelerating lens configured in the foregoing manner, when a beam emitted from the sample and having energy of 1keV is incident thereon, the beam is decelerated down to around 112eV at the exit of the lens.

If the values of the items (2) to (4) are adjusted as described above, the spherical aberration is corrected over the acceptance angle of $\pm 30°$. In case where the spherical surface whose central axis coincides with the optical axis is used as the mesh M in this manner, it is impossible to more effectively correct the spherical aberration than the case of using the spheroidal surface, but it is easy to process the lens. This is advantageous in the cost.

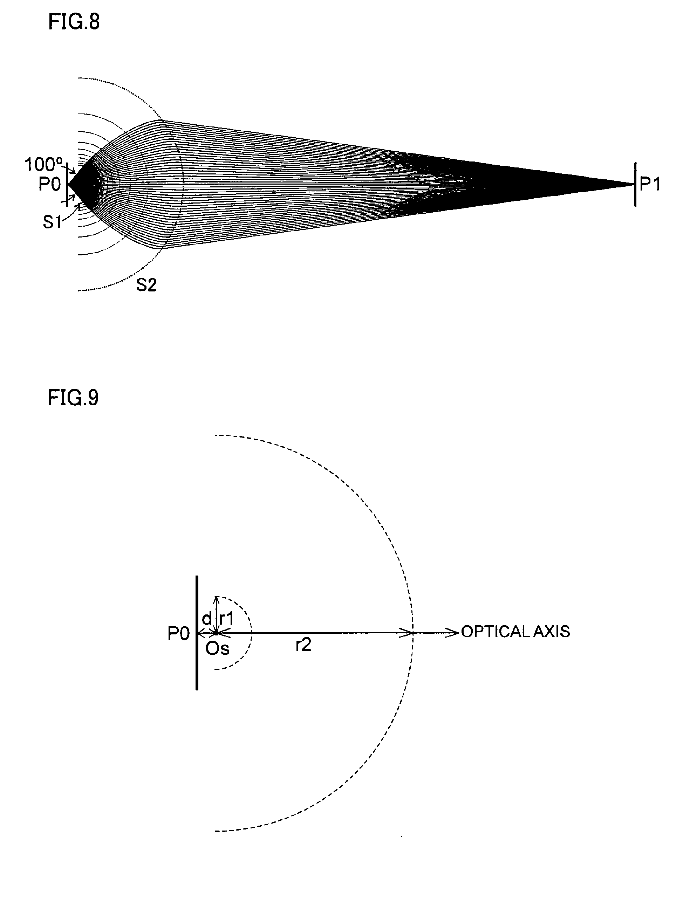

Further, in an example useful for understanding the invention, it is possible to allow a beam whose divergence angle is large to be incident thereon by using the spherical mesh. This can be realized by a configuration in which a plurality of spherical meshes different from each other in a radius are sequentially arranged with predetermined intervals from the object plane P0. With reference to Fig. 8 and Fig. 9, the following describes the spherical aberration correction decelerating lens configured so that two spherical meshes are provided. Fig. 8 is a cross sectional view illustrating the spherical aberration correction decelerating lens including two spherical meshes, i.e., an internal spherical mesh S1 and an external spherical mesh S2. Fig. 9 illustrates essential portions of the two spherical meshes, i.e., the internal spherical mesh S1 and the external spherical mesh S2 of Fig. 8.

As illustrated in Fig. 8, the spherical aberration correction decelerating lens including the two spherical meshes is configured so that the internal spherical mesh S1 having a small radius is positioned closer to the object plane P0 and the external spherical mesh S2 having a larger radius than that of the internal spherical mesh S1 is placed closer to the image plane P1. In case where energy of the beam emitted from the sample is 1keV, the internal spherical mesh S 1 is grounded so as to have an earth potential, and a voltage of -990V is applied to the external spherical mesh S2. Herein, a ratio of a radius r1 of the internal spherical mesh S1 and a radius r2 of the external spherical mesh S2, i.e., r2/r1 is 5.55, and a ratio of the distance d from the object plane P0 to the origin Os of the internal spherical mesh S1 and the radius r1 of the internal spherical mesh S1, i.e., d/r1 is 0.511.

Note that, the correction of the spherical aberration in the spherical aberration correction decelerating lens greatly relates to the ratio of the radius r1 of the internal spherical mesh S1 and the radius r2 of the external spherical mesh S2, i.e., r2/r1, and the ratio of the distance d from the object plane P0 to the origin Os of the internal spherical mesh S1 and the radius r1 of the internal spherical mesh S1, i.e., d/r1. Favorable ranges of r2/r1 and d/r1 depend on (i) a beam acceptance angle of the spherical aberration correction decelerating lens and (ii) a ratio of energy Ef of a beam finally outputted from the spherical aberration correction decelerating lens and energy Ei of the beam outputted from the object plane P0, Ef/Ei (i.e., depend on a deceleration ratio).

In the spherical aberration correction decelerating lens illustrated in Fig. 8, its acceptance angle is set to $\pm 50°$ and the deceleration ratio Ef/Ei is set to 0.01. As the acceptance angle is smaller, the spherical aberration is smaller, which results in a wider favorable range of d/r1. Adversely, if the acceptance angle is set large such as around $\pm 50°$, the spherical aberration is larger and a distance between the object plane P0 and the internal spherical mesh S1 is geometrically limited to a small distance. Thus, the beam emitted from the sample is more vertically incident on the internal spherical mesh S1, so that the beam is hardly bent. In this case, it is necessary to decrease the deceleration ratio Ef/Ei or to increase r2/r1 indicative of the ratio of the radius r2 of the external spherical mesh and the radius r1 of the internal spherical mesh in order to more effectively bend the beam so that the beam is converged onto the image plane P1.

Note that, in order to effectively converge the beam, it is preferable to simultaneously adjust the deceleration ratio Ef/Ei, r2/r1 indicative of the ratio of the radii r2 and r1, and d/r1 indicative of the ratio of the distance from the object plane P0 to the origin Os of the internal spherical mesh S1 and the radius r1 of the internal spherical mesh S1. In case where the acceptance angle is $\pm 50°$, it is preferable that the deceleration ratio ranges from around 0.1 to around 0.01 and r2/r1 ranges from around 4 to around 6 and d/r1 ranges from around 0.4 to around 0.6.

According to the foregoing configuration, the spherical aberration correction decelerating lens including the two spherical meshes, i.e., the internal spherical mesh S1 and the external spherical mesh S2 forms a spherically symmetric field as illustrated in Fig. 8, thereby increasing the acceptance angle of the beam emitted from the sample up to around $\pm 50°$. Note that, in the spherical aberration correction decelerating lens including the two spherical meshes, when a beam emitted from the sample and having energy of 1keV is incident thereon, the beam is decelerated down to 10eV at the exit of the lens. In this manner, compared with a spherical aberration correction decelerating lens having another configuration, the spherical aberration correction decelerating lens can greatly decelerate the beam emitted from the sample. Hence, if it is necessary to greatly decelerate the beam emitted from the sample, the spherical aberration correction decelerating lens including the two spherical meshes is favorably used.

Note that, in the spherical aberration correction decelerating lens described above, the first electrode EL1 or the internal spherical mesh S1 is grounded so as to have an earth potential, but is not limited to this configuration. That is, the spherical aberration correction decelerating lens may be configured so that voltages equal to a voltage applied to the sample placed on the object plane P0 are respectively added to voltages applied to the first electrode EL1 to the n-th electrode ELn or the internal spherical mesh S1 and the external spherical mesh S2. Note that, the voltage is applied to the sample placed on the object plane P0 by connecting the sample to the external power supply via a conducting wire or the like.

According to the foregoing configuration, even if each of the voltages applied to the first electrode EL1 to the n-th electrode ELn or the internal spherical mesh S1 and the external spherical mesh S2 varies, it is possible to converge the beam emitted from the sample onto the image plane P1. Further, by adjusting the voltage applied to the sample, it is possible to freely adjust each of the voltages applied to the first electrode EL1 to the n-th electrode ELn or the internal spherical mesh S1 and the external spherical mesh S2.

For example, in case where the spherical aberration correction decelerating lens of Fig. 2(a) is configured so that the distance from the object plane P0 to the image plane P1 is 500 mm and energy of the beam emitted from the sample is 1keV, the voltage applied to the first electrode EL1 is 0V, the voltage applied to the second electrode EL2 is around -443.96V, and the voltage applied to the third electrode EL3 is around -819.82V as described above.

Herein, in case where the voltage applied to the third electrode EL3 is 0V, it is possible to converge the beam emitted from the object plane P0 onto the image plane P1 by setting the voltage applied to the sample to around 819.82V, setting the voltage applied to the first electrode EL1 to around 819.82V, and setting the voltage applied to the second electrode EL2 to around 375.86V.

Note that, in case where the mesh M and the first electrode EL1 are provided separately from each other, a voltage equal to the voltage applied to the sample is added to each of the voltages applied to the mesh M to the n-th electrode ELn.

Further, in case of applying the voltage to the sample, it is preferable to provide a shield 16 so as to surround the sample with the mesh M as illustrated in Fig. 22. Fig.

22 is different from Fig. 2(a) in that the spherical aberration correction decelerating lens includes the shield 16 for keeping a potential of a peripheral portion of the sample constant. By providing the shield 16, it is possible to surround the sample with the shield 16 and the mesh M, thereby keeping a potential of the peripheral portion of the sample constant. Note that, it is preferable that the shield 16 is made of thin plate such as stainless or the like.

Further, in case of applying the voltage to the sample, it is preferable to provide such a shield 16 not only on the spherical aberration correction decelerating lens of Fig. 2(a) but also on each of all the aforementioned spherical aberration correction decelerating lenses.

Also, the spherical aberration correction decelerating lens may be configured so that a voltage lower than the voltage applied to the first electrode EL1 or the internal spherical mesh S1 is applied to the sample placed on the object plane P0.

For example, in case where the voltage applied to the first electrode EL1 or the internal spherical mesh S1 is 0V, the voltage applied to the sample is made negative, and in case where the voltage applied to the first electrode EL1 or the internal spherical mesh S1 is positive, the voltage applied to the sample is set to 0V. Note that, the voltage applied to the sample is not limited to the foregoing examples as long as the voltage applied to the sample is lower than the voltage applied to the first electrode EL1 or the internal spherical mesh S1. It does not matter whether the voltage is positive or negative.

In this case, voltages applied to the sample and the first electrode EL1 or the internal spherical are different from each other, so that energy of the beam emitted from the sample varies before being incident on the mesh M or the internal spherical mesh S1. Thus, the voltages applied to the first electrode EL1 to the n-th electrode ELn or the internal spherical mesh S1 and the external spherical mesh S2 are determined as follows.

First, the voltages applied to the second electrode EL2 to the n-th electrode ELn or the external spherical mesh S2 are set so that the beam whose energy has varied is converged onto the image plane P1 in case where the voltage applied to the first electrode EL1 or the internal spherical mesh S1 is 0V. The thus set voltage is regarded as a reference voltage.

Further, in case where each of the voltages applied to the first electrode EL1 or the internal spherical mesh S1 is obtained by adding a predetermined voltage to 0V, a voltage equal to the added voltage applied to the first electrode EL1 or the internal spherical mesh S1 is added also to each of the reference voltages applied to the second electrode EL2 to the n-th electrode ELn or the external spherical mesh S2. This makes it possible to converge the beam onto the image plane P1 even in case where energy of the beam emitted from the sample varies between the object plane P0 and the first electrode EL1 or the internal spherical mesh S1.

Note that, the voltages added to the voltages applied to the second electrode EL2 to the n-th electrode ELn or the internal spherical mesh S2 are not necessarily the same voltages as the voltages added to the voltage applied to the first electrode EL1 or the internal spherical mesh S1 and may be different from each other. However, in the first electrode EL1 to the n-th electrode ELn or the internal spherical mesh S1 and the external spherical mesh S2, it is necessary to adjust the voltage added to the voltage applied to each electrode so that the beam emitted from the sample is converged onto the image plane P1.

According to the foregoing configuration, a voltage lower than the voltage applied to the first electrode EL1 or the internal spherical mesh S1 is applied to the sample placed on the object plane P0, so that the beam emitted from the sample is accelerated between the object plane P0 and the mesh M or the internal spherical mesh S 1.

Hence, between the object plane P0 and the mesh M or the internal spherical mesh S1, the divergence angle of the beam becomes small and the incident angle at which the beam is incident on the mesh M or the internal spherical mesh S1 becomes small, so that it is possible to easily converge the beam onto the image plane P1. That is, the foregoing configuration makes it possible for the spherical aberration correction decelerating lens to accept a beam having a large divergence angle.

Note that, in case where the mesh M and the first electrode EL1 are provided separately from each other, a voltage lower than the voltage applied to the mesh M is applied to the sample placed on the object plane P0.

As described above, the spherical aberration correction decelerating lens corrects a spherical aberration occurring in an electron beam or an ion beam (hereinafter, referred to as "beam") emitted from an object plane P0 with a certain divergence angle.

According to this configuration, by applying an intentionally set voltage from the external power supply to each of the first electrode EL1 to the n-th electrode ELn each of which is constituted of a surface of a solid of revolution whose central axis coincides with the optical axis, it is possible to allow each electrode to decelerate the beam emitted from the object plane P0 and to form the decelerating convergence field for correcting the spherical aberration occurring in the beam. This makes it possible to decelerate the beam with the decelerating convergence field formed by each electrode even in case where a high energy beam is emitted from the object plane P1.

Also, by using as at least one of the electrodes the mesh M which has a concaved shape opposite to the object plane P0 and which is constituted of a surface of a solid of revolution whose central axis coincides with the optical axis, it is possible to realize a larger acceptance angle. Hence, in case where a beam having high energy and a large divergence angle is made incident on the spherical aberration correction decelerating lens of the present invention and is converged on the image plane and then is subsequently made incident on a lens provided on a subsequent stage, it is possible to converge the beam onto an image plane of the subsequent stage lens without applying a high voltage to an electrode of the subsequent stage lens.

[Spherical aberration correction lens system]

Generally, an electron lens is accompanied by a positive spherical aberration regardless of whether the electron lens is an electrostatic type or a magnetic field type. Hence, a beam emitted from a certain point of the object plane forms an image in a position closer to the object plane as its aperture angle with respect to the electron lens is larger. Thus, as the acceptance angle in the electron lens is larger, the image is more blurred.

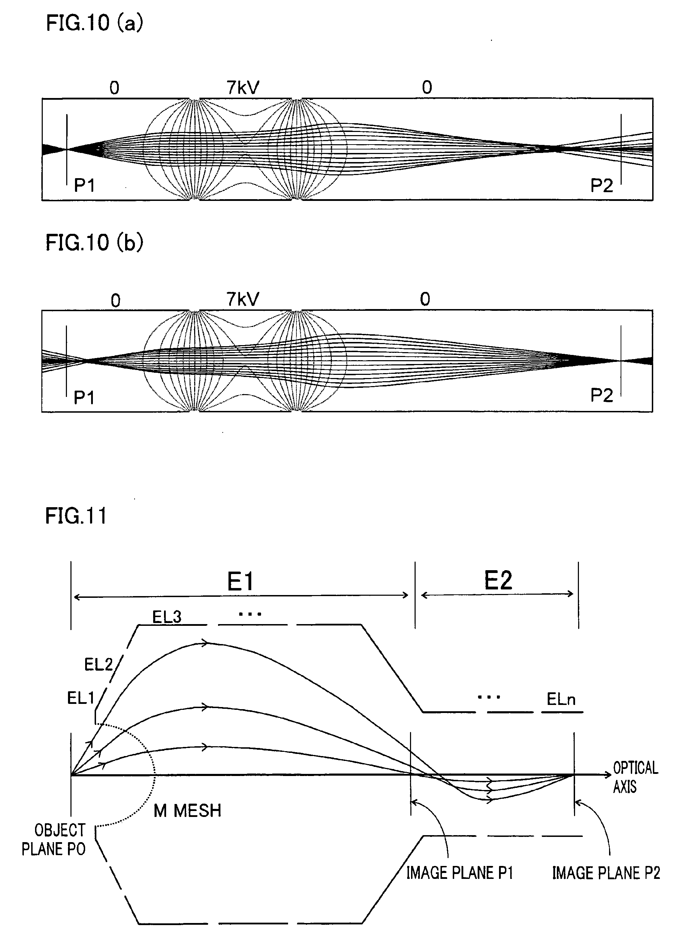

However, by giving an appropriate negative spherical aberration to the beam when the beam is incident on the electron lens, it is possible to cancel a positive spherical aberration occurring in the electron lens. With reference to Fig. 10(a) and Fig. 10(b), this configuration is described as follows. Each of Fig. 10(a) and Fig. 10(b) is a diagram considering a lens system including two lenses, i.e., a previous stage lens and a subsequent stage lens. In this diagram, only the subsequent stage lens is illustrated. Fig. 10(a) is a cross sectional view illustrating electron trajectories in case where a beam having a divergence angle of $\pm$ 12° is incident on the subsequent stage lens in the lens system including two lenses, i.e., the previous stage lens and the subsequent stage lens. Fig. 10(b) is a cross sectional view illustrating electron trajectories calculated so that the beam is converged onto a single point on an image plane P2 of the subsequent stage lens. Note that, the incident energy of the beam is 1keV.

The electron lens of Fig. 10(a) is configured so that the beam emitted from the sample is converged onto an image plane P1 of the previous stage lens. In this case, an image on the image plane P2 of the subsequent stage lens is more blurred due to a positive spherical aberration occurring in the subsequent stage lens. If the divergence angle of the beam which is incident on the electron lens is over around $\pm$ 10° in this manner, the spherical aberration in the image plane P2 of the subsequent stage lens is conspicuous.

However, the electron lens of Fig. 10(b) is configured so that the beam emitted from the sample is not converged onto the image plane P1 of the previous stage lens and a negative spherical aberration is given so as to cancel a positive spherical aberration occurring in the subsequent stage lens, thereby converging the beam onto the image plane P2 of the subsequent stage lens. That is, in the lens system including two lenses, i.e., the previous stage lens and the subsequent stage lens, an appropriate negative spherical aberration is given when the beam is incident on the previous stage lens so as to cancel the positive spherical aberration occurring in the subsequent stage lens. The spherical aberration correction lens of the present invention is based on such concept.

[Example 1]

Herein, with reference to Fig. 11 to Fig. 14, Example 1 of the spherical aberration correction lens system of the present invention is described as follows. Fig. 11 is a cross sectional view schematically illustrating a spherical aberration correction lens system of Example 1. Note that, a curve in this figure indicates trajectories of a beam emitted from an object plane.

As illustrated in Fig. 11, the spherical aberration correction lens system of Example 1 includes a first lens E1 and a second lens E2.

The first lens E1 is constituted of the aforementioned spherical aberration correction decelerating lens of the present invention. In the spherical aberration correction decelerating lens, at least one of (i) a ratio of a major axis to a minor axis in the mesh M, (ii) a voltage applied to each electrode, (iii) a distance from an object plane P0 to the mesh M, and (iv) a length of each electrode is adjusted so that a negative spherical aberration occurs in an image plane P1.

The second lens E2 is constituted of at least one electron lens. In this electron lens, a positive spherical aberration occurs. Note that, for simplification of descriptions, the following describes a configuration in which a single electron lens is used as the second lens E2. Either an electrostatic type electron lens or a magnetic field type electron lens may be used as the second lens E2. In case where the second lens E2 is constituted of a plurality of electron lenses, a combination of the electrostatic type and the magnetic field type may be used.

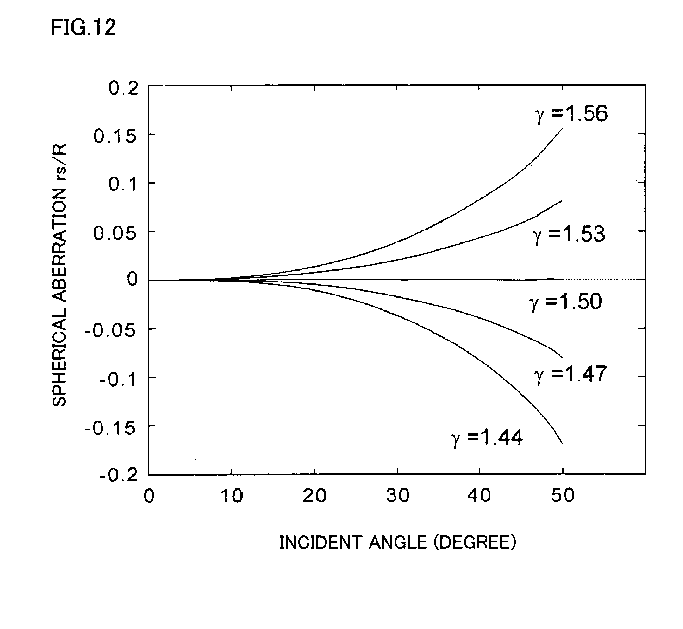

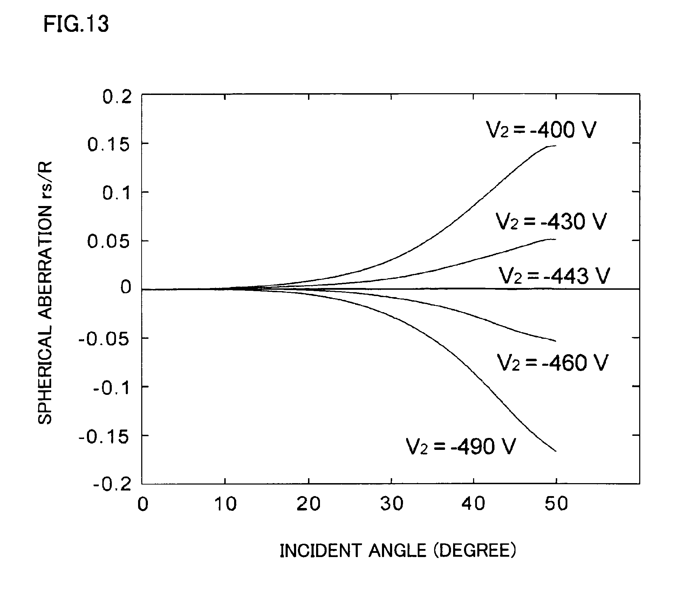

With reference to Fig. 12 and Fig. 13, the following describes a configuration in which the spherical aberration correction decelerating lens of the present invention is used to generate a negative spherical aberration on the image plane P1 in the spherical aberration correction lens system of Example 1. Fig. 12 is a graph illustrating a relationship between an incident angle of a beam and a spherical aberration in case where the ratio $\gamma$ of a major axis to a minor axis in the mesh M is 1.44, in case of 1.47, in case of 1.50, in case of 1.53, and in case of 1.56. Fig. 13 is a graph illustrating a relationship between an incident angle of a beam and a spherical aberration in case where a voltage $V_2$ applied to the second electrode EL2 is -490V, in case of -460V, in case of -443V, in case of -430V, and in case of -400V.

As illustrated in Fig. 12, in case where the ratio $\gamma$ of a major axis to a minor axis in the mesh M is 1.53 and in case of 1.56, the negative spherical aberration is larger as the incident angle of the beam which is incident on the spherical aberration correction decelerating lens is larger. Note that, compared with the case where the ratio $\gamma$ of a major axis to a minor axis in the mesh M is 1.53, the spherical aberration greatly varies with increase of the incident angle in the case where the ratio $\gamma$ of a major axis to a minor axis in the mesh M is 1.56. Further, in case where the ratio $\gamma$ of a major axis to a minor axis in the mesh M is 1.44 and in case of 1.47, the positive spherical aberration is larger as the incident angle of the beam which is incident on the spherical aberration correction decelerating lens is larger. Note that, compared with the case where the ratio $\gamma$ of a major axis to a minor axis in the mesh M is 1.47, the spherical aberration greatly varies with increase of the incident angle in the case where the ratio $\gamma$ of a major axis to a minor axis in the mesh M is 1.44. Also, in case where the ratio $\gamma$ of a major axis to a minor axis in the mesh M is 1.50, the spherical aberration is substantially constant regardless of the incident angle of the beam. Hence, in case where the ratio $\gamma$ of a major axis to a minor axis in the mesh M is $1.50 < \gamma < 1.56$, such a negative spherical aberration that $0 < rs / R < 0.15$ occurs on the image plane P1. Herein, "rs" represents a spherical aberration and "R" represents a radius of the lens.

As illustrated in Fig. 13, in case where the voltage $V_2$ applied to the second electrode EL2 is -430V and in case of -400V, the negative spherical aberration is larger as the incident angle of the beam which is incident on the spherical aberration correction decelerating lens is larger. Note that, compared with the case where the voltage $V_2$ applied to the second electrode EL2 is -430V, the spherical aberration greatly varies with increase of the incident angle in the case where the voltage $V_2$ applied to the second electrode EL2 is -400V. Also, in case where the voltage $V_2$ applied to the second electrode EL2 is -460V and in case of -490V, the positive spherical aberration is larger as the incident angle of the beam which is incident on the spherical aberration correction decelerating lens is larger. Note that, compared with the case where the voltage $V_2$ applied to the second electrode EL2 is -460V, the spherical aberration greatly varies with increase of the incident angle in the case where the voltage $V_2$ applied to the second electrode EL2 is -490V. Also, in case where the voltage $V_2$ applied to the second electrode EL2 is -443V, the spherical aberration is substantially constant regardless of the incident angle of the beam. Hence, in case where the voltage $V_2$ applied to the second electrode EL2 is $-443V < V_2 < -400V$, such a negative spherical aberration that $0 < rs / R < 0.15$ occurs on the image plane P1.

Although not shown, with increase of the length L1 of the first electrode EL1, that is, with increase of L1/R indicative of a ratio of the L1 of the first electrode EL1 and the radius R of the spherical aberration correction decelerating lens, a negative spherical aberration occurs. Although not shown, it is possible to control the sign (+ or -) and absolute value of the spherical aberration also by adjusting a distance from the object plane P0 to the mesh M.

In this manner, at least one of (a) the ratio of a major axis to a minor axis in the mesh M, (b) the voltage $V_2$ applied to the second electrode EL2, (c) the distance from the object plane P0 to the mesh M, and (d) the length of each electrode is adjusted, so that it is possible to generate a negative spherical aberration on the image plane P1. Thus, at least one of (a) the ratio of a major axis to a minor axis in the mesh M, (b) the voltage $V_2$ applied to the second electrode EL2, (c) the distance from the object plane P0 to the mesh M, and (d) the length of each electrode is suitably adjusted in accordance with a positive spherical aberration occurring in the second lens E2, thereby substantially canceling the spherical aberration on the image plane 2 of the second lens E2.

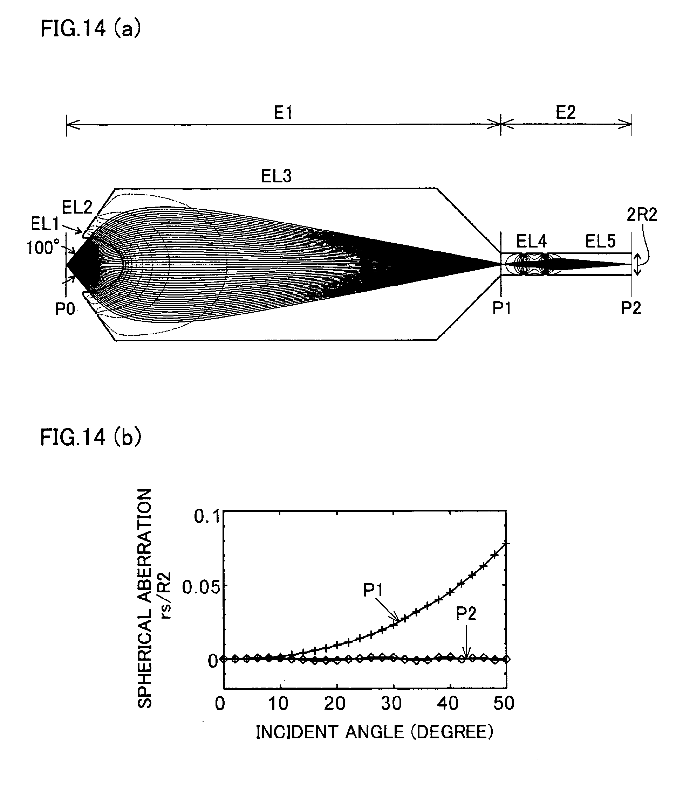

With reference to Fig. 14(a) and Fig. 14(b), the following describes a configuration in which the spherical aberration on the image plane P2 of the second lens E2 is substantially cancelled in the spherical aberration correction lens system of Example 1. Fig. 14(a) is a cross sectional view illustrating in more detail the configuration of the spherical aberration correction lens system of Example 1. Fig. 14(b) is a graph illustrating a relationship between an incident angle of a beam and a spherical aberration on the image plane P1 of the first lens E1 and a relationship between an incident angle of a beam and a spherical aberration on the image plane P2 of the second lens E2.

As illustrated in Fig. 14(b), if (a) the ratio of a major axis to a minor axis in the mesh M, (b) the voltage $V_2$ applied to the second electrode EL2, (c) the distance from the object plane P0 to the mesh M, and (d) L1/R indicative of the ratio of the L1 of the first electrode EL1 and the radius R of the spherical aberration correction decelerating lens are set so that a negative spherical aberration occurs, the negative spherical aberration on the image plane P1 of the first lens E1 is larger as the incident angle of the beam which is incident on the first lens E1 is larger. Also the positive spherical aberration occurring in the second lens E2 is larger as the incident angle of the beam which is incident on the first lens E1 is larger. As a result, on the image plane P2 of the second lens E2, the negative spherical aberration occurring on the image plane P1 and the positive spherical aberration occurring in the second lens E2 cancel each other regardless of the incident angle of the beam which is incident on the first lens E1, thereby substantially eliminating the spherical aberration.

Note that, as in the aforementioned configuration of the spherical aberration correction decelerating lens of the present invention, any number of electrodes may be provided on the first lens E1 as long as at least three electrodes are provided, and the number of the electrodes may be altered in accordance with the design of the spherical aberration correction lens system. In this case, it is preferable to suitably adjust at least one of (a) the ratio of a major axis to a minor axis in the mesh M, (b) the voltage V applied to each electrode, (c) the distance from the object plane P0 to the mesh M, and (d) the length of each electrode, in accordance with the number of electrodes provided on the first lens EL1. Further, also in the spherical aberration correction lens system of Example 1, it is possible to completely correct a spherical aberration by finely adjusting the shape of the mesh in accordance with Equation 1 or Equation 2 for example.

In the spherical aberration correction decelerating lens constituting the first lens E1, when a voltage applied to the n-th electrode ELn is set to 0V or close to 0V, a potential difference between (A) a member provided on a periphery of each of the n-th electrode ELn and the second lens E2 and (B) an electrode constituting the second lens E2 is smaller, so that discharge is suppressed.

Hence, discharge is less likely to occur than the case where a voltage greatly different from 0V is applied to the n-th electrode Eln and where thereby a potential difference between (A) a member provided on a periphery of each of the n-th electrode ELn and the second lens E2 and (B) an electrode constituting the second lens E2 is large and discharge is likely to occur. Therefore, there is small restriction in a configuration and an arrangement of members such as electrodes and the like. This makes it possible to achieve advantageous design in performances, a size, and the like of the system. Further, it is possible to converge a beam having higher energy by suppressing discharge, so that an analyzable energy range increases.

[Example 2]

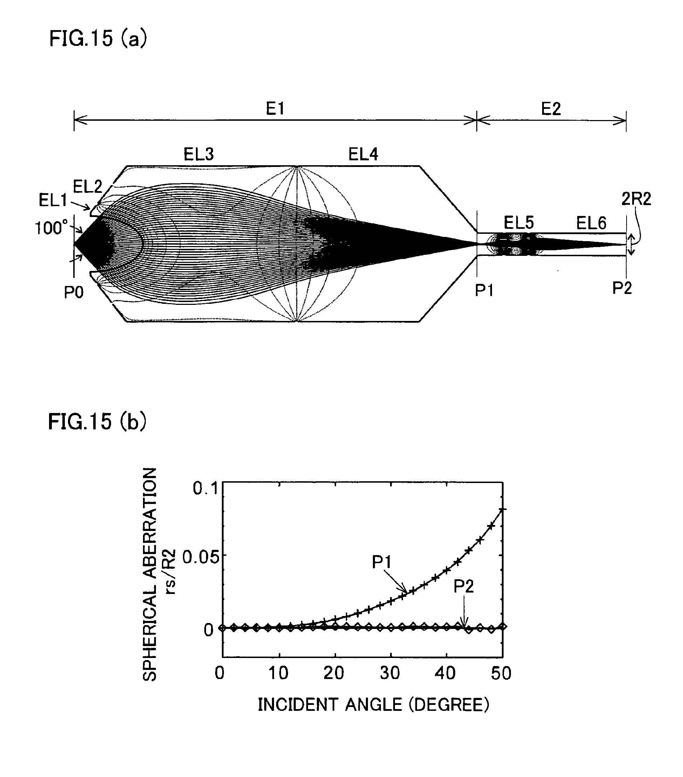

With reference to Fig. 15(a) and Fig. 15(b), Example 2 of the spherical aberration correction lens system of an example merely useful for understanding of the present invention is described as follows. Fig. 15(a) is a cross sectional view schematically illustrating a spherical aberration correction lens system of Example 2. Fig. 15(b) is a graph illustrating a relationship between an incident angle of a beam and a spherical aberration on the image plane P1 of the first lens E1 and a relationship between an incident angle of a beam and a spherical aberration on the image plane P2 of the second lens E2 in the spherical aberration correction system of Example 2. Note that, a continuous curve in this figure indicates trajectories of a beam emitted from an object plane.

As illustrated in Fig. 15(a), the spherical aberration correction lens system of Example 2 includes a first lens E1 and a second lens E2. The spherical aberration correction lens system of Example 2 is different from the spherical aberration correction lens system of Example 1 in that the first lens E1 is constituted of an einzel-type electron lens. As the einzel-type lens, an electron lens of Fig. 20 whose acceptance angle is $\pm 50°$ and an electron lens of Fig. 21 whose acceptance angle is $\pm 60°$ are favorably used. Note that, in Fig. 15(a), the electron lens whose acceptance angle is $\pm 50°$ is used.

Also in this case, as in the spherical aberration correction lens system of Example 1, by adjusting at least one of (a) the ratio of a major axis to a minor axis in the mesh M, (b) the voltage V applied to each electrode, (c) the distance from the object plane P0 to the mesh M, and (d) the length of each electrode, it is possible to generate a negative spherical aberration on the image plane P1 as illustrated in Fig. 15(b). Further, this negative spherical aberration and a positive spherical aberration occurring in the second lens E2 cancel each other, so that it is possible to substantially eliminate the spherical aberration on the image plane P2 of the second lens E2. Note that, also in the spherical aberration correction lens system of Example 2, it is possible to completely correct a spherical aberration by finely adjusting the shape of the mesh in accordance with Equation 1 or Equation 2 for example.

Note that, as in the spherical aberration correction lens system of Example 1, also the spherical aberration correction lens system of Example 2 may be arranged so that the positive spherical aberration occurring in the first lens E1 is cancelled by generating the negative spherical aberration in the second lens E2.

[Example 3]

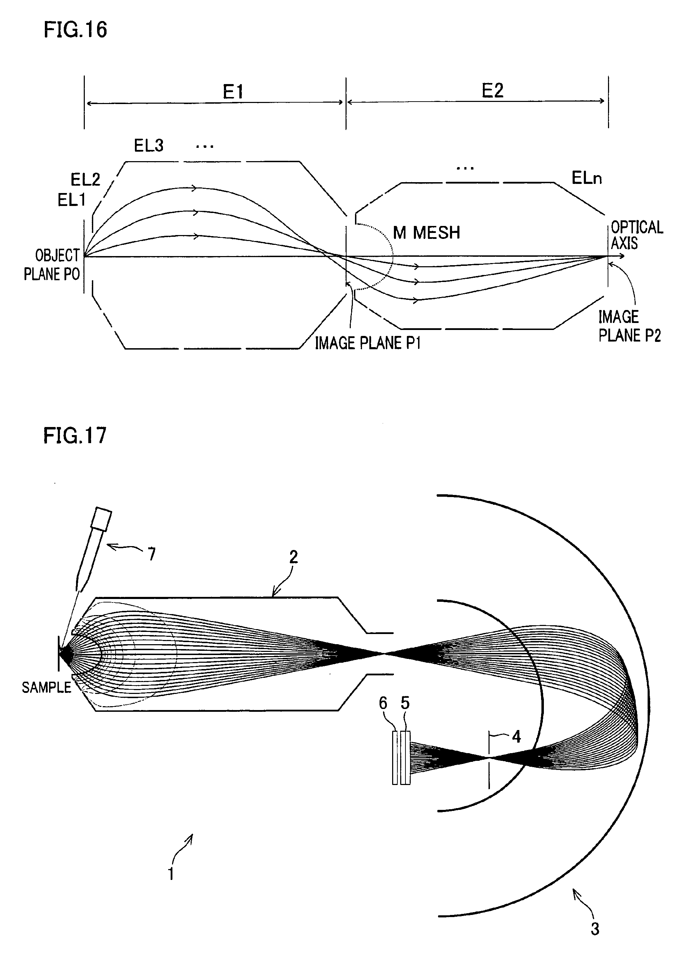

With reference to Fig. 16, Example 3 of the spherical aberration correction lens system of the present invention is described as follows. Fig. 16 is a cross sectional view schematically illustrating the spherical aberration correction lens system of Example 3. Note that, a curve in this figure indicates trajectories of a beam emitted from an object plane.

As illustrated in Fig. 16, the spherical aberration correction lens system of Example 3 includes a first lens E1 and a second lens E2. The spherical aberration correction lens system of the present Example is different from the spherical aberration correction lens system of Example 1 in an order in which the first lens E1 and the second lens E2 are arranged. That is, the first lens E1 is constituted of at least one electron lens, and the second lens E2 is constituted of the aforementioned spherical aberration correction decelerating lens of the present invention. In Example 3, the first lens E1 is configured so as to be capable of accepting the beam emitted from the sample with a large divergence angle, e.g., so as to be capable of accelerating the beam emitted from the sample and allowing the accelerated beam to be incident on an objective lens, thereby accepting the beam with a large divergence angle of around $\pm 60°$.

Note that, for simplification of descriptions, a single electron lens is used as the first lens E1. Further, either an electrostatic type electron lens or a magnetic field type electron lens may be used as the first lens E1. In case where the first lens E1 is constituted of a plurality of electron lenses, a combination of the electrostatic type and the magnetic field type may be used.

In the spherical aberration correction lens system of Example 3, a positive spherical aberration occurring in the first lens E1 is larger as a divergence angle of the beam emitted from the sample is larger. At the same time, also a divergence angle of the beam which is incident on the second lens E2 is larger. The spherical aberration correction decelerating lens is used as the second lens E2 of Example 3, so that the acceptance angle can be within $\pm 60°$. Thus, even in case where a beam having a large divergence angle is incident on the first lens E1, the beam can be incident on the second lens E2.

Further, also in Example 3, as in the spherical aberration correction lens system of Example 1, at least one of (a) the ratio of a major axis to a minor axis in the mesh M, (b) the voltage V applied to each electrode of the second lens E2, (c) the distance from the object plane P0 to the mesh M, and (d) the length of each electrode of the second lens E2 is adjusted so that a negative spherical aberration occurring in the second lens E2 cancels a large positive spherical aberration occurring in the first lens E1. This makes it possible to form a real image obtained by canceling the spherical aberration on the image plane P2 of the second lens E2 as illustrated in Fig. 16.

Note that, also in the spherical aberration correction lens system of Example 3, it is possible to completely correct a spherical aberration by finely adjusting the shape of the mesh in accordance with Equation 1 or Equation 2 for example.

Note that, in Example 3, the spherical aberration correction decelerating lens of the present invention is used as the second lens E2, but the present invention is not limited to this configuration. That is, an electron lens accompanied by a negative spherical aberration (e.g., a multipolar lens) may be used as the second lens E2. In this case, it is preferable that an electron lens of the present invention and generating a positive spherical aberration is used as the first lens E1. This makes it possible to accept a beam emitted from the object plane P0 so that an acceptance range is within $\pm 60°$. Also, an appropriate positive spherical aberration is given to the first lens E1 so as to correct a negative spherical aberration occurring in the second lens E2, so that the positive spherical aberration occurring in the first lens E1 is cancelled on the image plane P2 of the second lens E2.

As described above, the spherical aberration correction lens system of the present embodiment comprises: a first lens E1 for forming a real image having a positive or negative spherical aberration in response to a beam emitted from an object plane P0 with a certain divergence angle; and a second lens E2, provided at a subsequent stage of the first lens E1 so as to be positioned on the same axis as an optical axis of the first lens E1, for canceling the positive or negative spherical aberration occurring in the first lens E1, wherein the first lens E1 or the second lens E2 includes the mesh which has a concaved shape opposite to an object plane P0 and which is constituted of a surface of a solid of revolution so that a central axis of the concaved shape coincides with the optical axis, and an acceptance angle of the beam is within $\pm 60°$.

According to this configuration, a real image having a positive or negative spherical aberration is formed by the first lens E1 and the positive or negative spherical aberration is cancelled by the second lens E2 provided at the subsequent stage of the first lens E1 so as to be positioned on the same axis as the optical axis of the first lens E1. Thus, the spherical aberration correction lens system of the present embodiment can cancel the spherical aberration between a plurality of lenses, i.e., the first lens E1 provided at the previous stage and the second lens E2 provided at the subsequent stage.

[Electron spectrometer]

Next, with reference to Fig. 17, the following describes an electron spectrometer including the aforementioned spherical aberration correction decelerating lens or the aforementioned spherical aberration correction lens system. Fig. 17 is a block diagram schematically illustrating the electron spectrometer of the present invention.

As illustrated in Fig. 17, the electron spectrometer of the present embodiment includes an input lens 2, a spherical mirror analyzer 3, an aperture 4, a micro channel plate (MCP) 5, and a screen 6. The electron spectrometer of the present embodiment is **characterized in that** the spherical aberration correction decelerating lens or the spherical aberration correction lens system of the present invention is used as the input lens 2. Note that, in Fig. 17, the spherical aberration correction decelerating lens of the present invention is used as the input lens 2.

Herein, how an electron spectrometer 1 of the present embodiment operates is described as follows.

First, a light emission member 7 emits light such as ultraviolet ray, x ray, and the like or electron beam to a sample (specimen) placed opposite to the mesh M of the input lens 2. Electrons emitted from a surface of the sample as a result of emission of the light or the electron beam is decelerated and converged by the input lens 2 and is incident on the spherical mirror analyzer 3. The electrons which are incident on the spherical analyzer 3 are sorted in view of energy by the aperture 4 provided at the exit of the spherical analyzer 3, and then the electrons are multiplied by the micro channel plate 5 and projected onto a screen.

Note that, a lens or an aperture for adjusting energy resolution ability may be provided around an entrance of the spherical mirror analyzer 3. The spherical mirror analyzer 3 is used in the present embodiment, but the present invention is not limited to this configuration and an electrostatic hemispherical analyzer, a cylindrical mirror analyzer, or the like may be used. However, the spherical mirror analyzer 3 is different from the electrostatic hemispherical analyzer, the cylindrical mirror analyzer, or the like in that the spherical mirror analyzer 3 is free from any aperture aberration and is capable of giving substantially the same energy resolution ability as the electrostatic hemispherical analyzer over an acceptance angle of around $\pm 20°$. Hence, it is preferable to use the spherical mirror analyzer 3.

According to the foregoing configuration, a high energy beam can be accepted with a large acceptance angle of around $\pm 60°$ and can be converged after decelerating. This makes it possible to enhance sensitivity, function, and energy resolution ability of the electron spectrometer.

[Photoelectric microscope]

Next, with reference to Fig. 18, the following describes a photoelectron microscope 10 including the aforementioned spherical aberration correction decelerating lens or the aforementioned spherical aberration correction lens system of the present invention. Fig. 18 is a block diagram illustrating an example of the photoelectron microscope according to the present invention.

As illustrated in Fig. 18, the photoelectron microscope 10 of the present embodiment includes an objective lens 11, a first lens system 12, an energy analyzer 13, a second lens system 14, and a detector 15. The photoelectron microscope 10 is **characterized in that** the spherical aberration correction decelerating lens of the present invention or the spherical aberration correction lens system of the present invention is used as the objective lens 11.

Herein, how the photoelectron microscope 10 of the present embodiment operates is described as follows.

First, a light emission member 7 emits light such as ultraviolet ray, x ray, and the like or electron beam to a sample (specimen) placed opposite to the mesh M of the objective lens 11. Electrons emitted from a surface of the sample as a result of emission of the light or the electron beam is converged by the objective lens 11 and is incident on the detector 15 via the first lens system 12, the energy analyzer 13, and the second lens system 14.

In the first lens system 12 and the second lens system 14, an imaging mode or an angle-resolved mode (diffraction mode) is switched, energy resolution is adjusted, an image is enlarged, or a similar operation is performed. In the imaging mode, not only an enlarged image of a real space but also a spectrum of electrons emitted from a specific region of the sample can be obtained by altering the energy of electrons to be selected and measuring the number of the electrons with the detector 15. Further, in the angle-resolved mode, it is possible to measure angular distribution of emitted electrons over an extremely large emission angle by single measurement.

Note that, the energy analyzer 13 is provided in the present embodiment, but the present invention is not limited to this configuration and it may be so configured that the energy analyzer 13 is not provided. Further, one of the electrostatic hemisphere analyzer, the spherical mirror analyzer, the cylindrical mirror analyzer, and the like can be freely selected as the energy analyzer 13 in accordance with a purpose.

Note that, it is preferable to design the objective lens 11 in consideration for a combination with other components, performances and the like required in the photoelectron microscope 10. Further, in case of allowing the electrons emitted from the objective lens 11 to be incident on a subsequent stage lens or an analyzer accompanied by an aperture aberration or a similar member, it is preferable to design the system so as to correct also the aberration.

The present invention is not limited to the description of the embodiments above, but may be altered by a skilled person within the scope of the claims. An embodiment based on a proper combination of technical means disclosed in different embodiments is encompassed in the technical scope of the present invention.

In order to solve the foregoing problems, a spherical aberration correction decelerating lens of the present invention corrects a spherical aberration occurring in an electron beam or an ion beam (hereinafter, referred to as "beam") emitted from a predetermined object plane position with a certain aperture angle as defined in claim 1.

According to this arrangement, the decelerating convergence field formed by each electrode can decelerate the beam even when a high energy beam is emitted from the object plane.

Further, by using as at least one of the electrodes the mesh which has a concaved shape opposite to an object plane and which is constituted of a surface of a solid of revolution so that a central axis of the concaved shape coincides with the optical axis, it is possible to achieve a large acceptance angle. Hence, in case where a beam having high energy and a large divergence angle is made incident on the spherical aberration correction decelerating lens of the present invention and the beam converged onto the image plane is sequentially made incident on the lens provided at the subsequent stage, the beam can be converged onto the image plane of the subsequent stage lens without applying a high voltage to the electrode of the subsequent stage lens.

Hence, in case where the spherical aberration correction decelerating lens of the present invention is applied to an electron spectrometer or a photoelectron microscope, a beam having high energy and a large aperture angle can be made incident thereon. This makes it possible to greatly enhance sensitivities and functions of the electron spectrometer and the photoelectron microscope.

Also, the spherical aberration correction decelerating lens of the present invention may be arranged so that the spherical aberration occurring in the beam is corrected by adjusting at least one of (a) a ratio of a major axis to a minor axis in the mesh, (b) a length of each electrode, (c) a distance from the predetermined object plane position to the mesh, and (d) a voltage applied to said each electrode.

According to this arrangement, by adjusting at least one of (a) a ratio of a major axis to a minor axis in the mesh, (b) a length of each electrode, (c) a distance from the predetermined object plane position to the mesh, and (d) a voltage applied to said each electrode, it is possible to correct the spherical aberration occurring in the beam emitted from the predetermined object plane position.

Further, the spherical aberration correction decelerating lens of the present invention may be arranged so that (a) a ratio of a major axis to a minor axis in the mesh, (b) a length of each electrode, (c) a distance from the predetermined object plane position to the mesh, and (d) a voltage applied to said each electrode are set so that an acceptance angle of the beam is within $\pm 60°$.

According to this arrangement, (a) a ratio of a major axis to a minor axis in the mesh, (b) a length of each electrode, (c) a distance from the predetermined object plane position to the mesh, and (d) a voltage applied to said each electrode are adjusted, thereby accepting the beam emitted from the object plane so that an acceptance angle of the beam is within $\pm 60°$. This allows the spherical aberration correction decelerating lens of the present invention to decelerate and converge the beam whose divergence angle is up to around $\pm 60°$.

Hence, in case where the spherical aberration correction decelerating lens of the present invention is applied to an electron spectrometer or a photoelectron microscope, a beam having high energy and a large divergence angle can be made incident thereon. This makes it possible to greatly enhance sensitivities and functions of the electron spectrometer and the photoelectron microscope.

The spherical aberration correction decelerating lens of the present invention may be arranged so that for the mesh , constituted of a spheroidal surface whose central axis coincides with the optical axis, $\gamma = a/b$ ( indicative of a ratio of a major axis to a minor axis in the spheroidal surface) is within a range from around 1.3 to around 1.7 where "a" represents the major axis and "b" represents the minor axis.

In case of the exasmple merely useful for understanding the invention, where the shape of the mesh is a spherical surface whose central axis coincides with the optical axis, the limit of the beam acceptance angle is around $\pm 30°$. Hence, for the invention, as described above, the shape of the mesh is constituted of the spheroidal surface whose central axis coincides with the optical axis, thereby increasing the beam acceptance angle to $\pm 60°$ compared with the examplary case where the shape of the mesh is constituted of a spherical surface.

Therefore, in case where the spherical aberration correction decelerating lens of the present invention is applied to an electron spectrometer or a photoelectron microscope, a beam having high energy and a large aperture angle can be made incident thereon. This makes it possible to greatly enhance sensitivities and functions of the electron spectrometer and the photoelectron microscope.

Further, the spherical aberration correction decelerating lens of the present invention may be arranged so that $\gamma = a/b$ indicative of a ratio of a major axis to a minor axis in the mesh is within a range from around 1.4 to around 1.6, where "a" represents the major axis and "b" represents the minor axis,

when the following conditions (i), (ii), and (iii) are satisfied:

> (i) there are four electrodes one of which includes said one or more meshes;
> (ii) an acceptance angle of the beam is ±50°; and
> (iii) a distance from the object plane to an image plane is 500 mm.

Further, the spherical aberration correction decelerating lens of the present invention may be arranged so that a length of a first electrode provided adjacent to the mesh so as to be positioned on a side of an image plane is within a range from around 1 mm to around 10 mm, and a length of a second electrode provided adjacent to the first electrode so as to be positioned on the side of the image plane is within a range from around 5 mm to around 25 mm, when the foregoing conditions (i), (ii), and (iii) are satisfied.

Also, the spherical aberration correction decelerating lens of the present invention may be arranged so that a distance from the object plane to an origin of a spheroidal surface is within a range from around 10 mm to around 25 mm, when the foregoing conditions (i), (ii), and (iii) are satisfied.

Further, the spherical aberration correction decelerating lens of the present invention is arranged so that a voltage applied to the mesh is 0V, a voltage applied to the first electrode is 0V, a voltage applied to the second electrode is within a range from around -100V to around -550V, and a voltage applied to a third electrode provided adjacent to the second electrode so as to be positioned on the side of the image plane is within a range from around -550V to around -950V, when energy of the beam is 1keV.

As described above, when the foregoing conditions (i), (ii), and (iii) are satisfied, at least one of (a) the ratio of a major axis to a minor axis in the mesh, (b) the length of each electrode, (c) the distance from the predetermined object plane position to the mesh, and (d) the voltage applied to each electrode is adjusted in a favorable range, thereby accepting the beam emitted from the object plane so that an acceptance angle of the beam is within a range of ±50°. This allows the spherical aberration correction decelerating lens of the present invention to decelerate and converge the beam whose divergence angle is up to around ±50°.

Further, a spherical aberration correction decelerating lens of an example merely useful for understanding the present invention may be arranged so that the meshes are constituted of at least two surfaces of solids of revolution, having radii different from each other, whose central axes coincide with the optical axis, and (A) a ratio of the radii of the meshes, (B) a ratio of energy of the beam in its entrance and energy of the beam in its exit, and (C) a ratio of a distance from the object plane to a center of an internal spherical mesh which faces the object plane out of the meshes are set so that an acceptance angle of the beam is within a range from ±0° to ±50°.

According to this arrangement, in case where the meshes are constituted of at least two surfaces of solids of revolution, having radii different from each other, whose central axes coincide with the optical axis, (A) a ratio of the radii of the meshes, (B) a ratio of energy of the beam in its entrance and energy of the beam in its exit, and (C) a ratio of a distance from the object plane to a center of an internal spherical mesh which faces the object plane out of the meshes are adjusted, thereby accepting the beam emitted from the object plane so that an acceptance angle of the beam is within a range from ±0° to ±50°. This allows the spherical aberration correction decelerating lens to decelerate and converge the beam whose aperture angle is up to around ±50°.

Hence, in case where the spherical aberration correction decelerating lens is applied to an electron spectrometer or a photoelectron microscope, a beam having high energy and a large aperture angle can be made incident thereon. This makes it possible to greatly enhance sensitivities and functions of the electron spectrometer and the photoelectron microscope.

Further, the spherical aberration correction decelerating lens may be arranged so that each of the meshes is a spherical surface whose central axis coincides with the optical axis.

In case where a single mesh constituted of a spherical surface whose central axis coincides with the optical axis is used, the limit of the beam acceptance angle is around ±30°. Thus, as described above, there are used the meshes constituted of at least two surfaces of solids of revolution, having radii different from each other, whose central axes coincide with the optical axis, and a ratio of the radii of the meshes is set so that an acceptance angle of the beam is within a range from ±0° to ±50°, so that the spherical aberration correction decelerating lens forms a spherically symmetric field. This makes it possible to increase the acceptance angle to around ±50°. In case where each of the meshes is constituted of a spherical surface whose central axis coincides with the optical axis, it is easier to process the meshes than the case where each of the meshes is constituted of the spheroidal surface whose central axis coincides with the optical axis. This is advantageous in view of the cost.

The spherical aberration correction decelerating lens of the present invention may be arranged so that a voltage equal to a voltage applied to the sample placed on the predetermined object plane is added to the voltage applied to each electrode.

According to this arrangement, even if the voltage applied to each electrode varies, the beam emitted from the sample can be converged onto the image plane. Also, by adjusting the voltage applied to the sample, it is possible to freely adjust the voltage applied to each electrode.

The spherical aberration correction decelerating lens of the present invention may be arranged so that a voltage lower than a voltage applied to the mesh is applied to the sample placed on the predetermined object plane.

According to this arrangement, a voltage lower than the voltage applied to the mesh is applied to the sample placed on the predetermined object plane, so that the beam emitted from the sample is accelerated between the predetermined object plane and the mesh.

Hence, between the predetermined object plane and the mesh, a divergence angle of the beam becomes small and an incident angle of the beam which is incident on the mesh becomes small, so that the beam can be easily converged onto the image plane. Therefore, according to the foregoing configuration, the spherical aberration correction decelerating lens of the present invention can accept a beam having a larger divergence angle.

A spherical aberration correction lens system of the present invention is defined in claim 9.

Generally, an electron lens is accompanied by a positive spherical aberration regardless of whether the electron lens is an electrostatic type or a magnetic field type. Hence, as a beam emitted from a certain point of an object plane has a larger aperture angle with respect to the electron lens, a resultant image is formed at a position closer to the object plane. Therefore, as the electron lens has a larger acceptance angle, the resultant image is more blurred.

Hence, in case where a general electron lens, i.e., an electron lens accompanied by a positive spherical aberration is used as the first lens or the second lens of the spherical aberration correction lens system of the present invention, a lens bringing about a negative spherical aberration is used as the other lens to appropriately give the negative spherical aberration so that the lens cancels the positive spherical aberration of the electron lens. Therefore, as to the beams emitted from the object plane, the spherical aberration is cancelled at the image plane of the second lens. Specifically, as to a real image formed in the first lens and having a positive or negative spherical aberration, the positive or negative spherical aberration is cancelled by the second lens disposed at the subsequent stage of the first lens so as to be positioned on the same axis as the optical axis of the first lens.

Thus, for example, by using a lens having a mesh and bringing about a negative spherical aberration as the first lens and by using a lens bringing about a positive spherical aberration as the second lens, the first lens can accept the beam emitted from the object plane so that an acceptance angle is within ±60°. Also, by giving an appropriate negative spherical aberration in the first lens so as to correct the positive spherical aberration occurring in the second lens, it is possible to cancel the spherical aberration on the image plane of the second lens.

Further, for example, in case of using as the first lens a lens which can accept a beam emitted from the object plane with a large acceptance angle and which is accompanied by a positive spherical aberration and using as the second lens a lens having a mesh and accompanied by a negative spherical aberration, the second lens can accept the beam so that an acceptable angle is within ±60°. This allows the beam having a large positive spherical aberration occurring in the first lens to be incident on the second lens. Also, by giving an appropriate negative spherical aberration in the second lens so as to correct a positive spherical aberration occurring in the first lens, it is possible to cancel, on the image plane of the second lens, the large positive spherical aberration occurring in the first lens.

Further, for example, in case of using as the first lens a lens having a mesh and bringing about a positive spherical aberration and using as the second lens as a lens accompanied by a negative spherical aberration (e.g., a multipolar lens), the first lens can accept the beam emitted from the object plane so that an acceptance angle of the beam is within ±60°. Also, by giving an appropriate positive spherical aberration in the first lens so as to correct a negative spherical aberration occurring in the second lens, it is possible to cancel, on the image plane of the second lens, the negative spherical aberration occurring in the first lens.

Hence, the spherical aberration correction lens system of the present invention can cancel, on the image plane of the subsequent stage lens, the spherical aberration of the beam emitted from the object plane.

Therefore, in case where the spherical aberration correction lens system is applied to an electron spectrometer or a photoelectron microscope, a space resolution ability can be enhanced compared with the case where the spherical aberration is corrected by using only the previous stage lens.

The spherical aberration correction lens system of the present invention is arranged so that one of the first lens and the second lens which includes the mesh is the aforementioned spherical aberration correction decelerating lens of the present invention.

An electron spectrometer of the present invention includes the aforementioned spherical aberration correction decelerating lens or the aforementioned spherical aberration correction lens system of the present invention.

According to this configuration, by using the spherical aberration correction decelerating lens or the spherical aberration correction lens system which can accept a high energy beam with a large acceptance angle, it is possible to greatly enhance sensitivity and function of the electron spectrometer.

A photoelectron microscope of the present invention includes the aforementioned spherical aberration correction decelerating lens or the aforementioned spherical aberration correction lens system of the present invention.

According to this configuration, by using the spherical aberration correction decelerating lens or the spherical aberration correction lens system which can accept a high energy beam with a large acceptance angle, it is possible to greatly enhance sensitivity and function of the photoelectron microscope.

INDUSTRIAL APPLICABILITY

The spherical aberration correction decelerating lens and the spherical aberration correction lens system of the present invention can substantially eliminate a spherical aberration, so that they can be favorably used as an input lens of an electron spectrometer and an objective lens of a photoelectron microscope.

**Claims**

1. A spherical aberration correction decelerating lens, which corrects a spherical aberration occurring in an electron beam or an ion beam (hereinafter, referred to as "beam") emitted from a predetermined object plane (P0) position with a certain divergence angle,
said spherical aberration correction decelerating lens comprising at least three electrodes (EL1, EL2, EL3, ELn) and a single mesh (M), each electrode being constituted of a surface of a solid of revolution whose central axis coincides with an optical axis and each of which receives an intentionally set voltage applied by an external power supply being comprised by the sperical aberration correction deceleration lens,
wherein one of the electrodes includes said single mesh which has a concaved shape opposite to the object plane and which is constituted of a surface of a solid of revolution so that a central axis of the concaved shape coincides with the optical axis, and
the spherical aberration correction decelerating lens being adapted to form ,in use, a decelerating convergence field for converging the beam emitted from the object plane onto an image plane (P1) while decelerating the beam, wherein the voltage applied to each of the electrodes causes the beam to be decelerated and causes formation of only the decelerating convergence field for correcting the spherical aberration occurring in the beam, and
the mesh is constituted of a spheroidal surface whose central axis coincides with the optical axis, and wherein wherein

   a) a ratio of a major axis (a) to a minor (b) in the mesh, b) a length (L1, L2) of each electrode, c) a distance (d1) from the predetermined object plane position to the mesh, and d) the voltage applied to said each electrode are such that an acceptance angle of the spherical aberration correction decelerating lens for said beam is within a range from $\pm 50°$ to $\pm 60°$.

2. The spherical aberration correction decelerating lens as set forth in claim 1, wherein at least one of a) the ratio of the major axis to the minor axis in the mesh, b) the length of each electrode, c) the distance from the predetermined object plane position to the mesh, and d) the voltage applied to said each electrode is such that the spherical aberration in the beam is corrected.

3. The spherical aberration correction decelerating lens as set forth in claim 1, wherein $\gamma = a/b$ indicative of the ratio of the major axis to the minor axis in the spheroid is within a range from 1.3 to 1.7 where "a" represents the major axis and "b" represents the minor axis.

4. The spherical aberration correction decelerating lens as set forth in claim 2, wherein
$\gamma = a/b$ indicative of the ratio of the major axis to the minor axis in the mesh is within a range from 1.4 to 1.6, where "a" represents the major axis and "b" represents the minor axis,
and wherein
the following conditions (i), (ii), and (iii) are satisfied:

   (i) there are four electrodes one of which includes said mesh;
   (ii) the acceptance angle of the beam is $\pm 50°$; and
   (iii) a distance from the object plane to the image plane is 500 mm.

5. The spherical aberration correction decelerating lens as set forth in claim 2, wherein
a length of a first electrode provided adjacent to the mesh so as to be positioned on a side of the image plane is within a range from 1 mm to 10 mm, and a length of a second electrode provided adjacent to the first electrode so as to be positioned on the side of the image plane is within a range from 5 mm to 25 mm,
and wherein
the following conditions (i), (ii), and (iii) are satisfied:

(i) there are four electrodes one of which includes said mesh;
(ii) the acceptance angle of the beam is ±50°; and
(iii) a distance from the object plane to an image plane is 500 mm.

6. The spherical aberration correction decelerating lens as set forth in claim 2, wherein the distance from the object plane to an origin of a spheroidal surface is within a range from 10 mm to 25 mm, when the following conditions (i), (ii), and (iii) are satisfied:

(i) there are four electrodes one of which includes said mesh;
(ii) the acceptance angle of the beam is ±50°; and
(iii) a distance from the object plane to an image plane is 500 mm.

7. The spherical aberration correction decelerating lens as set forth in claim 1, adapted such that, in use, a voltage equal to a voltage applied to a sample placed on the predetermined object plane is added to the voltage applied to each electrode.

8. The spherical aberration correction decelerating lens as set forth in claim 1, adapted such that, in use, a voltage lower than a voltage applied to the mesh is applied to a sample placed on the predetermined object plane.

9. A spherical aberration correction lens system, comprising: a first lens (E1) adapted to form a real image having a positive or negative spherical aberration in response to an electron beam or an ion beam (hereinafter, referred to as "beam") emitted from a predetermined object plane position with a certain divergence angle; and a second lens (E2) , provided at a subsequent stage of the first lens so as to be positioned on the same axis as an optical axis of the first lens, for canceling the positive or negative spherical aberration occurring in the first lens, wherein the spherical aberration correction decelerating lens as set forth in claim 1 is provided as the first lens or the second lens.

10. An electron spectrometer, comprising the spherical aberration correction decelerating lens as set forth in claim 1 or the spherical aberration correction lens system as set forth in claim 9.

11. A photoelectron microscope, comprising the spherical aberration correction decelerating lens as set forth in claim 1 or the spherical aberration correction lens system as set forth in claim 9.

**Patentansprüche**

1. Eine die sphärische Aberration korrigierende Verzögerungslinse, welche eine sphärische Aberration korrigiert, die in einem Elektronenstrahl oder einem Ionenstrahl (hier im folgenden als "Strahl" bezeichnet) auftritt, der von einer vorbestimmten Objektebenen-(P0) Position mit einem bestimmten Abweichungswinkel emittiert wird, wobei die die sphärische Aberration korrigierende Verzögerungslinse mindestens drei Elektroden (EL1, EL2, EL3, ELn) und ein einzelnes Netz (M) umfasst, wobei jede Elektrode auf der Oberfläche eines sich drehenden Festkörpers dargestellt ist, dessen Mittelachse mit einer optischen Achse zusammenfällt und wobei jede von diesen eine bewusst eingestellte Spannung empfängt, die durch eine externe Energiezufuhr zugeführt wird, die durch die die sphärische Aberration korrigierende Verzögerungslinse umfasst wird, wobei eine der Elektroden das einzelne Netz einschließt, das eine konkave Form gegenüber der Objektebene aufweist und das auf der Oberfläche eines sich drehenden Festkörpers dargestellt ist, so dass eine Mittelachse der konkaven Form mit der optischen Achse zusammenfällt, und die die sphärische Aberration korrigierende Verzögerungslinse so angepasst ist, um bei der Verwendung ein verzögerndes Konvergenzfeld zur Verzögerung des Strahls zu bilden, der von der Objektebene auf eine Bildebene (P1) emittiert wird während einer Verzögerung des Strahls, wobei die an jede der Elektroden angelegte Spannung verursacht, dass der Strahl verzögert wird, und die Bildung lediglich des verzögernden Konvergenzfelds zur Korrektur der sphärischen Aberration, die in dem Strahl auftritt verursacht, und das Netz aus einer kugelförmigen Oberfläche gebildet ist, dessen Mittelachse mit der optischen Achse zusammenfällt, und wobei

a) ein Verhältnis von einer Hauptachse (a) zu einer Nebenachse (b) in dem Netz, b) eine Länge (L1, L2) jeder Elektrode, c) einer Entfernung (d1) von der vorbestimmten Objektebenen-Position zu dem Netz und d) der an jede Elektrode angelegten Spannung so sind, dass ein Akzeptanzwinkel der die sphärische Aberration korrigierenden Verzögerungslinse für den Strahl innerhalb eines Bereichs von ±50° bis ±60° liegt.

2. Die die sphärische Aberration korrigierende Verzögerungslinse gemäß Anspruch 1, wobei mindestens eines von a) dem Verhältnis von der Hauptachse zu der Nebenachse in dem Netz, b) der Länge jeder Elektrode, der Entfernung von der vorbestimmten Objektebenen-Position zu dem Netz und d) die an jede Elektrode angelegte Spannung so ist, dass die sphärische Aberration im Strahl korrigiert wird.

3. Die die sphärische Aberration korrigierende Verzögerungslinse gemäß Anspruch 1, wobei γ = a/b, welches das Verhältnis der Hauptachse zu der Nebenachse in der Kugelform anzeigt, in einem Bereich von 1,3 bis 1,7 liegt, wobei "a" die Hauptachse darstellt und "b" die Nebenachse darstellt.

4. Die die sphärische Aberration korrigierende Verzögerungslinse gemäß Anspruch 2, wobei γ = a/b, welches das Verhältnis der Hauptachse zu der Nebenachse in dem Netz anzeigt, in einem Bereich von 1,4 bis 1,6 liegt, wobei "a" die Hauptachse darstellt und "b" die Nebenachse darstellt, und wobei die folgenden Bedingungen (i), (ii) und (iii) erfüllt sind:

 (i) es sind vier Elektroden vorhanden, von denen eine das Netz einschließt;
 (ii) der Akzeptanzwinkel des Strahls ist ±50°; und
 (iii) eine Entfernung von der Objektebene zu der Bildebene ist 500 mm.

5. Die die sphärische Aberration korrigierende Verzögerungslinse gemäß Anspruch 2, wobei eine Länge einer ersten Elektrode, die angrenzend an das Netz zur Verfügung gestellt ist, um so auf einer Seite der Bildebene angeordnet zu sein, innerhalb eines Bereichs von 1 mm bis 10 mm ist, und eine Länge einer zweiten Elektrode die angrenzend an die erste Elektrode zur Verfügung gestellt ist, um so auf der Seite der Bildebene angeordnet zu sein, innerhalb eines Bereichs von 5 mm bis 25 mm ist, und wobei die folgenden Bedingungen (i), (ii) und (iii) erfüllt sind:

 (i) es sind vier Elektroden vorhanden, von denen eine das Netz einschließt;
 (ii) der Akzeptanzwinkel des Strahls ist ±50°; und
 (iii) eine Entfernung von der Objektebene zu der Bildebene ist 500 mm.

6. Die die sphärische Aberration korrigierende Verzögerungslinse gemäß Anspruch 2, wobei die Entfernung von der Objektebene zu einem Ursprung einer kugelförmigen Oberfläche innerhalb eines Bereichs von 10 mm bis 25 mm liegt, wenn die folgenden Bedingungen (i), (ii) und (iii) erfüllt sind:

 (i) es sind vier Elektroden vorhanden, von denen eine das Netz einschließt;
 (ii) der Akzeptanzwinkel des Strahls ist ±50°; und
 (iii) eine Entfernung von der Objektebene zu der Bildebene ist 500 mm.

7. Die die sphärische Aberration korrigierende Verzögerungslinse gemäß Anspruch 1, so angepasst, dass bei der Verwendung eine Spannung gleich zu einer Spannung, die auf eine Probe angewandt wird die auf der vorbestimmten Objektebene platziert wird, zu der an jede Elektrode angelegten Spannung hinzugefügt wird.

8. Die die sphärische Aberration korrigierende Verzögerungslinse gemäß Anspruch 1, so angepasst, dass bei der Verwendung eine Spannung geringer als eine Spannung, die auf das Netz angewandt wird zu der Probe hinzugefügt wird, die auf der vorbestimmten Objektebene platziert wird.

9. Ein die sphärische Aberration korrigierendes Linsensystem, umfassend: eine erste Linse (E1), so angepasst um ein reales Bild zu bilden, das eine positive oder negative sphärische Aberration in Antwort auf einen Elektronenstrahl oder einem Ionenstrahl (hier im folgenden als "Strahl" bezeichnet) aufweist, der von einer vorbestimmten Objektebenen-Position mit einem bestimmten Abweichungswinkel emittiert wird; und eine zweite Linse (E2), mit der Voraussetzung, dass bei einer anschließenden Phase die erste Linse so ist, um auf derselben Achse wie eine optische Achse der ersten Linse positioniert zu sein, zu einer Auslöschung der positiven oder negativen sphärischen Aberration die in der ersten Linse auftritt, wobei die die sphärische Aberration korrigierende Verzögerungslinse gemäß Anspruch 1 als die erste Linse oder die zweite Linse zur Verfügung gestellt wird.

10. Elektronenspektrometer, umfassend die die sphärische Aberration korrigierende Verzögerungslinse gemäß Anspruch 1 oder das die sphärische Aberration korrigierende Linsensystem gemäß Anspruch 9.

11. Photoelektronen-Mikroskop, umfassend die die sphärische Aberration korrigierende Verzögerungslinse gemäß Anspruch 1 oder das die sphärische Aberration korrigierende Linsensystem gemäß Anspruch 9.

**Revendications**

1. Une lentille à modération de correction d'aberration sphérique, qui corrige une aberration sphérique se produisant dans un faisceau d'électrons ou un faisceau d'ions (ci-après désigné par le terme "faisceau") émis à partir d'une position de plan d'objet prédéterminée (P0) avec un angle de divergence donné,
ladite lentille à modération de correction d'aberration sphérique comprenant au moins trois électrodes (EL1, EL2, EL3, ELn) et un maillage unique (M), chaque électrode étant constituée d'une surface d'un solide de révolution dont l'axe central coïncide avec un axe optique et chacune d'elles reçoit une tension définie intentionnellement appliquée par une alimentation électrique externe se composant de la lentille à modération de correction d'aberration sphérique, où une des électrodes comprend ledit maillage unique qui possède une forme concave opposée au plan d'objet et qui est constituée d'une surface d'un solide de révolution de sorte qu'un axe central de la forme concave coïncide avec l'axe optique, et
la lentille à modération de correction d'aberration sphérique étant adaptée de façon à former, en utilisation, un champ de convergence de décélération destiné à la convergence du faisceau émis à partir du plan d'objet sur un plan d'image (P1) pendant la décélération du faisceau, où la tension appliquée à chacune des électrodes amène le faisceau à être décéléré et entraîne la formation de seulement le champ de convergence de décélération de façon à corriger l'aberration sphérique se produisant dans le faisceau, et
le maillage est constitué d'une surface sphéroïdale dont l'axe central coïncide avec l'axe optique, et où

    a) un rapport d'un axe majeur (a) sur un axe mineur (b) dans le maillage, b) une longueur (L1, L2) de chaque électrode, c) une distance (d1) de la position de plan d'objet prédéterminée au maillage, et d) la tension appliquée à ladite chaque électrode sont tels qu'un angle d'acceptation de la lentille à modération de correction d'aberration sphérique pour ledit faisceau se situe à l'intérieur d'une plage de $\pm 50°$ à $\pm 60°$.

2. La lentille à modération de correction d'aberration sphérique selon la Revendication 1, où au moins un élément parmi a) le rapport de l'axe majeur sur l'axe mineur dans le maillage, b) la longueur de chaque électrode, c) la distance de la position de plan d'objet prédéterminée au maillage, et d) la tension appliquée à ladite chaque électrode est tel que l'aberration sphérique dans le faisceau est corrigée.

3. La lentille à modération de correction d'aberration sphérique selon la Revendication 1, où $\gamma = a/b$ indicatif du rapport de l'axe majeur sur l'axe mineur dans le sphéroïde se situe à l'intérieur d'une plage de 1,3 à 1,7 où "a" représente l'axe majeur et "b" représente l'axe mineur.

4. La lentille à modération de correction d'aberration sphérique selon la Revendication 2, où
$\gamma = a/b$ indicatif du rapport de l'axe majeur à l'axe mineur dans le maillage se situe à l'intérieur d'une plage de 1,4 à 1.6, où "a" représente l'axe majeur et "b" représente l'axe mineur, et où les conditions suivantes (i), (ii), et (iii) sont satisfaites :

    (i) il $\gamma$ a quatre électrodes dont l'une comprend ledit maillage,
    (ii) l'angle d'acceptation du faisceau est de $\pm 50°$, et
    (iii) une distance du plan d'objet au plan d'image est de 500 mm.

5. La lentille à modération de correction d'aberration sphérique selon la Revendication 2, où
une longueur d'une première électrode installée adjacente au maillage de façon à être positionnée sur un côté du plan d'image se situe à l'intérieur d'une plage de 1 mm à 10 mm et une longueur d'une deuxième électrode installée adjacente à la première électrode de façon à être positionnée sur le côté du plan d'image se situe à l'intérieur d'une plage de 5 mm à 25 mm,
et où les conditions suivantes (i), (ii) et (iii) sont satisfaites :

    (i) il y a quatre électrodes dont l'une comprend ledit maillage,
    (ii) l'angle d'acceptation du faisceau est de $\pm 50°$, et
    (iii) une distance du plan d'objet à un plan d'image est de 500 mm.

6. La lentille à modération de correction d'aberration sphérique selon la Revendication 2, où
la distance du plan d'objet à une origine d'une surface sphéroïdale se situe à l'intérieur d'une plage de 10 mm à 25 mm, lorsque les conditions suivantes (i), (ii) et (iii) sont satisfaites :

    (i) il y a quatre électrodes dont l'une comprend ledit maillage,

(ii) l'angle d'acceptation du faisceau est de $\pm 50°$, et

(iii) une distance du plan d'objet à un plan d'image est de 500 mm.

7. La lentille à modération de correction d'aberration sphérique selon la Revendication 1, adaptée de sorte que, en utilisation, une tension égale à la tension appliquée à un échantillon placé sur le plan d'objet prédéterminé soit ajoutée à la tension appliquée à chaque électrode.

8. La lentille à modération de correction d'aberration sphérique selon la Revendication 1, adaptée de sorte que, en utilisation, une tension inférieure à une tension appliquée au maillage soit appliquée à un échantillon placé sur le plan d'objet prédéterminé.

9. Un système de lentille de correction d'aberration sphérique, comprenant : une première lentille (E1) adaptée de façon à former une image réelle possédant une aberration sphérique positive ou négative en réponse à un faisceau d'électrons ou un faisceau d'ions (ci-après désigné par le terme "faisceau") émis à partir d'une position de plan d'objet prédéterminée avec un angle de divergence donné, et une deuxième lentille (E2) placée au niveau d'un étage subséquent de la première lentille de façon à être positionnée sur le même axe qu'un axe optique de la première lentille, de façon à annuler l'aberration sphérique positive ou négative se produisant dans la première lentille, où

la lentille à modération de correction d'aberration sphérique selon la Revendication 1 est fournie en tant que première lentille ou deuxième lentille.

10. Un spectromètre électronique, comprenant la lentille à modération de correction d'aberration sphérique selon la Revendication 1 ou le système de lentille de correction d'aberration sphérique selon la Revendication 9.

11. Un microscope photoélectronique, comprenant la lentille à modération de correction d'aberration sphérique selon la Revendication 1 ou le système de lentille de correction d'aberration sphérique selon la Revendication 9.

FIG.1

FIG.2 (a)

FIG.2 (b)

## FIG.3

FIG.4

FIG.5

RATIO $\gamma$ OF MAJOR AXIS TO MINOR AXIS

FIG.6

FIG.7

FIG.8

FIG.9

FIG.10 (a)

FIG.10 (b)

FIG.11

FIG.12

FIG.13

FIG.14 (a)

FIG.14 (b)

FIG.15 (a)

FIG.15 (b)

## FIG.16

## FIG.17

FIG.18

FIG.19

FIG.20 (a)

FIG.20 (b)

$$\gamma = a / b$$

FIG.21

FIG.22

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4358680 A
- EP 1170778 A

- JP 8111199 A